# EUROPÄISCHE PATENTSCHRIFT

(11) **EP 3 376 902 B1**
(45) Veröffentlichungstag und Bekanntmachung des Hinweises auf die Patenterteilung: **13.01.2021**
(21) Anmeldenummer: 16820170.5
(22) Anmeldetag: 03.11.2016
(51) Int. Cl.: A47B 96/20, B32B 17/00, E04F 15/00, E04B 2/72, E04C 2/00, H02G 3/38, H05K 3/00

(54) **FOLIE UND BELAG**
FILM AND COVERING
FILM ET REVÊTEMENT

(30) Priorität: 17.11.2015 DE 202015007865 U; 20.11.2015 DE 202015007999 U; 03.06.2016 DE 102016006628; 02.09.2016 DE 102016010583
(43) Veröffentlichungstag der Anmeldung: 26.09.2018
(73) Patentinhaber: Parador GmbH, 48653 Coesfeld (DE)
(72) Erfinder: PETERSEN, Frank, 48653 Coesfeld (DE); VERSTEGGE, Christian, 48599 Gronau-Epe (DE); DAMIECKI, David, 48653 Coesfeld (DE); WOLF, Matthias, 48653 Coesfeld-Lette (DE)
(74) Vertreter: Von Rohr Patentanwälte Partnerschaft mbB
(86) Internationale Anmeldenummer: PCT/EP2016/025135
(87) Internationale Veröffentlichungsnummer: WO 2017/084760

(56) Entgegenhaltungen:
- DE-A1- 10 239 579
- DE-A1-102009 020 627
- DE-A1-102011 005 735

## Beschreibung

Die Erfindung betrifft eine Verwendung einer Folie zur Beschichtung von Boden-, Wand- oder Deckenbelägen und/oder von Möbelbauteilen, mit wenigstens einer Trägerschicht, mit wenigstens einer Dekorschicht und/oder wenigstens einer oberseitigen Deckschicht und mit einer unterseitigen Haftschicht, insbesondere einer Klebschicht. Die Erfindung betrifft ferner die Verwendung einer solchen Folie zur Renovierung, Restaurierung und/oder Reparatur eines Boden-, Wand- und/oder Deckenbelages und/oder eines Möbelbauteil und/oder zur zumindest bereichsweisen Angleichung des Dekors zweier unterschiedliche Beläge, insbesondere Boden-, Wand-, und/oder Deckenbeläge, und/oder zur zumindest bereichsweisen Angleichung des Dekors eines Belags an das Dekor eines Möbelbauteils, sowie ein Verfahren zur Beschichtung von eine Mehrzahl von Belagselementen aufweisenden Boden-, Wand- und/oder Deckenbelägen oder von Möbelbauteilen mit einer Folie. Schließlich betrifft die Erfindung auch eine Verwendung eines Belags, insbesondere Boden-, Wand- oder Deckenbelags mit wenigstens einem Belagselement, insbesondere einem Plattenkörper und/oder einem Rollenmaterial.

Werden im Baubereich Böden, Wände oder Decken mit einem Belag verkleidet, ist es in aller Regel so, dass vor dem Verlegen des Belags ein Design zur Erzielung eines bestimmten optischen Eindrucks ausgewählt werden muss. Darüber hinaus ist es erforderlich, dass elektrische Komponenten und haustechnische Installationen, die üblicherweise hinter der Verkleidung angebracht werden sollen, eingerichtet werden müssen, bevor der Belag auf die zu verkleidende Fläche aufgebracht wird. Nach dem Verlegen des Belags sind die diesbezüglichen Auswahlparameter in der Regel fixiert, so dass eine Veränderung oder Einflussnahme nur noch mit großem Aufwand möglich ist. Dies gilt gleichermaßen für den Zugang zu hinter dem Belag vorhandenen Einrichtungen wie für die Veränderung eines einmal gewählten Designs bzw. der Belagsgestaltung.

Nach Beschädigungen des Belags oder infolge einer Abnutzung, die insbesondere bei Bodenbelägen auftreten kann, sind in der Regel Renovierungs- bzw. Restaurierungsarbeiten oder Reparaturen bzw. Ausbesserungen nötig. Derartige Arbeiten sind üblicherweise sehr aufwendig, da häufig wesentliche Teile des Belags entfernt werden müssen, um Zugang zu den beschädigten Belagselementen oder zu hinter dem Belag befindlichen Einrichtungen zu erhalten.

Aus der DE 20 2013 003 421 U1 ist eine Dekorselbstklebefolie bekannt, welche zur dekorativen Beschichtung einer Oberfläche eingesetzt werden kann. Dies erlaubt grundsätzlich, mittels einer Folie eine Oberfläche mit einem bestimmten Dekor zu versehen. Nachteilig ist hierbei jedoch stets, dass zur Einrichtung oder Veränderung insbesondere einer elektrischen Funktionalität im Bereich der Oberfläche, beispielsweise eines Bodens, einer Wand oder einer Decke ein aufgebrachter Belag, gegebenenfalls zusammen mit der aufgebrachten Folie, in unterschiedlich großem Umfang entfernt werden muss, um den Zugang für entsprechende Arbeiten freizulegen Ähnliche Folien sind ebenfalls bereits aus der DE 10 2011 005 735 A1 sowie der DE 10 2009 020 627 A1 bekannt.

Vor diesem Hintergrund ist es Aufgabe der vorliegenden Erfindung, hier Abhilfe zu schaffen, und eine einfache Reparatur oder Änderung eines Belags als solchen oder von hinter einem Belag angeordneten Einrichtungen zu ermöglichen, wobei insbesondere eine einfache Instandsetzung oder Veränderung des optischen Eindrucks des Belags möglich und eine hohe Flexibilität in Bezug auf die Ausgestaltung elektrischer Installationen im Bereich des Belags gegeben sein soll.

Die vorgenannte Aufgabe wird erfindungsgemäß durch eine Verwendung einer Folie mit den Merkmalen gemäß Anspruch 1 gelöst. Vorteilhafte Weiterbildungen sind Gegenstand der Unteransprüche.

Durch eine zumindest bereichsweise vorgesehene Funktionsschicht mit einer gedruckten Schaltung lassen sich funktionale Elemente, insbesondere elektrische oder elektronische Komponenten, auf sehr flexible Weise im Zusammenhang mit der Folie einsetzen. Eine Nachrüstung einer Oberfläche, beispielsweise eines Bodens, einer Wand oder einer Decke, mit derartigen Komponenten kann somit schlicht durch das Aufbringen einer erfindungsgemäß verwendeten Folie erfolgen. Es hat sich gezeigt, dass ein Rückbau eines vorhandenen Boden-, Wand- oder Deckenbelags oder gar ein Aufstemmen der dahinterliegenden Struktur sich durch die erfindungsgemäße Verwendung der Folie in den meisten Fällen erübrigt.

Durch ein erfindungsgemäßes Aufbringen der Folie auf einen vorhandenen Belag lässt sich somit zum einen, insbesondere nachträglich, das Dekor bzw. das optische Erscheinungsbild des Belages verändern oder korrigieren. Zum anderen lassen sich auf einfache Weise funktionale Elemente nachrüsten, die über die Gestaltung der rein passiven Erscheinung des Belages hinausgehen und diesem einen zusätzlichen Nutzwert verleihen.

Durch unterschiedliche Ausgestaltung einer Dekorschicht der erfindungsgemäß verwendeten Folie kann einer Oberfläche, insbesondere einem Belag oder einem Möbelbauteil, durch Aufbringen der Folie nicht nur grundsätzlich ein bestimmtes optisches Erscheinungsbild verliehen werden, sondern ein gegebenes Design der Oberfläche auch nachträglich verändert werden. Dies eröffnet Möglichkeiten, nach einer Beschädigung oder Abnutzung der Oberfläche und einer damit verbundenen Beeinträchtigung ihrer optischen Erscheinung notwendige Renovierungs- oder Restaurierungsarbeiten auf einfache Weise, nämlich beispielsweise durch einfaches Aufkleben der Folie, vorzunehmen. Eine beschädigte Oberfläche kann somit in den betroffenen Bereichen oder auch ganzflächig instand gesetzt werden.

Zur Reparatur bzw. Ausbesserung kann die Folie insbesondere dekorgleich mit der zu beschichtenden Oberfläche ausgebildet sein. Auf diese Weise lässt sich das Dekor in den beschädigten Bereichen instandsetzen, ohne dass Übergänge zu dem umliegenden, unbeschichteten Dekor der Oberfläche erkennbar sind.

Über die Instandsetzung oder Veränderung des Designs der Oberfläche hinaus oder alternativ hierzu lässt sich durch die gedruckte Funktionalität in der Funktionsschicht der erfindungsgemäß verwendeten Folie ein an sich passiver Belag oder ein reguläres Möbelstück in einfacher Weise zu einem aktiven, funktionalen Einrichtungselement aufwerten.

Durch die Aufbringung funktionaler Elemente auf eine vorhandene Oberfläche ergeben sich Vorteile insbesondere gegenüber ihrer Anordnung beispielsweise hinter einer Wand- oder Bodenverkleidung. Es ist insbesondere nicht erforderlich, dass bereits zum Zeitpunkt der Verkleidung einer Wand, eines Bodens oder einer Decke mit einem Belag entsprechende Vorkehrungen getroffen werden, welche die Art und Weise späterer funktionaler Elemente im betreffenden Bereich sowie deren Anordnung festlegen. Es versteht sich dabei, dass auch unterschiedliche Folien mit verschiedenen Funktionalitäten in gewünschter und nahezu beliebiger Weise, selbst übereinander, miteinander kombiniert werden können. Verändert sich die Anwendungssituation, lässt sich die vorhandene Funktionalität leicht durch Austausch der durch die erfindungsgemäße Folie bereitgestellten funktionalen Elemente bewirken.

Durch die Integration funktioneller Einheiten in die erfindungsgemäß verwendete Folie wird eine gewünschte Funktionalität in dezenter Weise bereitgestellt. Das optische Erscheinungsbild, das maßgeblich durch das Dekor der Dekorschicht der Folie bestimmt wird, wird also nicht durch rein funktionale Elemente gestört. Mittels der erfindungsgemäßen Verwendung der Folie ist es somit insbesondere möglich, eine Oberfläche mit einem vorhandenen Dekor mit einer zusätzlichen Funktionalität auszurüsten, ohne das Dekor zu stören. Hierzu wird das Dekor der Dekorschicht der Folie dem Dekor der ursprünglichen Oberfläche derart angepasst, dass sich die aufgebrachte Folie in unauffälliger Weise in das Gesamtbild einfügt, jedoch dabei die erweiterte Funktionalität durch die Funktionsschicht bereitgestellt wird.

Bei der erfindungsgemäßen Verwendung der Folie im verlegten Zustand bildet eine Haftschicht stets die unterste Schicht, während eine Deckschicht den obersten Teil des Schichtverbundes darstellt. Insofern ist die Funktionsschicht stets zwischen der Deckschicht und der Haftschicht angeordnet. Im Fall einer Dekorschicht, die bei der erfindungsgemäß verwendeten Folie vorgesehen sein kann, aber nicht vorgesehen sein muss, kann die Funktionsschicht bevorzugt unterhalb der Dekorschicht, d. h. zwischen der Dekorschicht und der Haftschicht, angeordnet sein. Alternativ oder zusätzlich kann die Funktionsschicht oder eine weitere Funktionsschicht jedoch bedarfsweise auch oberhalb der Dekorschicht, d. h. zwischen der Dekorschicht und der Deckschicht, vorgesehen sein.

Bei einer bevorzugten Ausführungsform der erfindungsgemäßen Verwendung der Folie weist die Funktionsschicht wenigstens einen Sensor zur Erfassung einer physikalischen Größe auf. Ein solcher Sensor dient insbesondere zur Ermittlung der Temperatur und/oder der Beleuchtungsstärke und/oder von auf die Folie bzw. die beschichtete Oberfläche wirkender Feuchtigkeit und/oder eines auf die Folie wirkenden Drucks. Das Signal des Sensors kann insbesondere dazu benutzt werden, Stellglieder eines Regelkreises derart zu steuern, dass ein Sollwert für die gemessene physikalische Größe erreicht wird. Dies betrifft beispielsweise die Temperatur oder die Beleuchtungsstärke. Die Stellglieder eines Regelkreises, die aufgrund eines Sensorsignals aktiviert bzw. angesteuert werden, können sowohl außerhalb der Folie vorgesehen sein als auch in Form von Aktoren der Funktionsschicht der Folie vorliegen.

Mit einem Drucksensor kann die Berührung der Folie detektiert werden. Wird die Folie auf einen Bodenbelag aufgebracht, lässt sich auf diese Weise beispielsweise feststellen ob ein Raum betreten wird. Die erfindungsgemäße Verwendung der Folie kann somit eine Nachrüstlösung für eine Raumüberwachung darstellen. Neben einer Funktion als Einbruchschutz ist es hierdurch beispielsweise auch möglich, zu registrieren, wenn eine hilfsbedürftige Person stürzt, so dass entsprechende Hilfsmaßnahmen eingeleitet werden können. Mittels der erfindungsgemäßen Verwendung der Folie lässt sich also beispielsweise ein Boden in einer Seniorenwohnung auf einfache und kostengünstige Weise mit einem solchen Hilfssystem nachrüsten.

Alternativ oder zusätzlich zu einer Anordnung des Sensors in der Funktionsschicht kann der Sensor auch in einer separaten zusätzlichen Sensorschicht vorgesehen sein. Hieraus ergeben sich unterschiedliche Vorteile, die abhängig sind von der Beschaffenheit des Sensors. Durch eine Anordnung des Sensors in der Funktionsschicht erhöht sich der Integrationsgrad, so dass eine geringere Gesamtdicke der Folie erreicht werden kann. Demgegenüber kann es in bestimmten Fällen jedoch erforderlich sein, den Sensor von der Funktionsschicht zu entkoppeln, beispielsweise um ihn im Schichtaufbau der Folie näher zur Oberseite der Folie anzuordnen.

In einer weiteren bevorzugten Ausführungsform weist die erfindungsgemäß verwendete Folie in der Funktionsschicht einen Aktor in Form einer Leuchtschicht auf. Die Leuchtschicht kann insbesondere als Elektrolumineszenzschicht ausgebildet sein oder ein oder mehrere Lichtquellen in Form von Leuchtdioden (LEDs) aufweisen. Eine Elektrolumineszenzfolie eignet sich besonders zu einer weitgehend homogenen Lichtabgabe über eine große, vorzugsweise die gesamte Fläche der Folie. Sie kann zudem in einfacher Weise, beispielsweise durch Beschnitt, in eine nahezu beliebige Form gebracht werden. Hieraus ergibt sich die Möglichkeit, auch die gesamte Folie als solche für einen Freiformbeschnitt geeignet auszubilden, ohne dass hierdurch die Eigenschaften der Leuchtschicht verlorengehen oder eingeschränkt werden. Durch die hohe mechanische Flexibilität einer Elektrolumineszenzfolie bleibt auch die Flexibilität der Folie als solcher in hohem Maße erhalten. Zudem wird das Risiko einer Beschädigung der Leuchtschicht durch äußere Einwirkung, etwa beim Betreten eines mit der Folie beschichteten Bodenbelags, erheblich verringert.

Erfindungsgemäß kann ein Aktor der Funktionsschicht der verwendeten Folie auch als mechanischer Aktor ausgebildet sein, durch den ein elektrisches Signal in eine mechanische Bewegung umgewandelt wird. Ein schallemittierendes Element stellt hierbei eine Sonderform eines mechanischen Aktors dar, bei der eine mechanische Schwingung mit entsprechender Frequenz und ausreichender Amplitude akustisch wahrnehmbar ist.

Durch wenigstens ein der Funktionsschicht zugeordnetes schallemittierendes Element kann eine aktive Lärmkompensation erreicht werden. Hierdurch kann beispielsweise Trittschall oder allgemeiner Raumschall reduziert werden. Zur aktiven Lärmkompensation wird in der Regel von einem akustischen Sensor erfasster Schall über das schallemittierende Element mit gleicher Frequenz, jedoch mit einer um eine Halbwelle versetzten Phase wiedergegeben. Im Ergebnis löschen sich die empfangene und die abgegebene Schallwelle nach dem Prinzip der destruktiven Interferenz gegenseitig aus. Dadurch kann eine akustisch ruhige Umgebung erzeugt werden. Durch Nachrüstung einer erfindungsgemäßen Folie zur aktiven Lärmkompensation lässt sich eine Geräuschreduzierung, beispielsweise in Wohnbereichen, ohne aufwendige Dämmmaßnahmen, insbesondere nachträglich, erreichen.

Ein mechanischer Aktor wird beispielsweise durch ein piezoelektrisches Element dargestellt. Bei einem solchen bewirkt eine angelegte elektrische Spannung eine mechanische Deformation des Piezokristalls. Die Frequenz einer angelegten, sich im zeitlichen Verlauf periodisch ändernden Spannung kann auf diese Weise fühlbar und/oder hörbar gemacht werden.

Ferner kann die Funktionsschicht bei einer weiteren bevorzugten Ausführungsform der erfindungsgemäßen Verwendung der Folie eine Anzeigeeinrichtung aufweisen.

Die Anzeigeeinrichtung kann dabei, insbesondere zur Wiedergabe von Informationen bzw. Daten, als LC-Display oder als Matrixdisplay ausgebildet sein. Ein Matrixdisplay erlaubt durch die unabhängige Ansteuerung seiner Pixel, aus denen sich das Anzeigebild zusammensetzt, grundsätzlich beliebige Muster, Graphiken oder allgemein Bilddaten wiederzugeben. Die Auflösung bzw. Bildqualität der Wiedergabe ist dabei von der Anzahl und Dichte der Pixel des Matrixdisplays abhängig. Die Bildpunkte eines solchen Matrixdisplays werden vorzugsweise durch Leuchtdioden (LEDs) oder organische Leuchtdioden (OLEDs) gebildet.

Die Anzeigeeinrichtung kann alternativ oder zusätzlich als elektronisches Papier ausgebildet sein, welches auch üblicherweise bei E-Book-Readern eingesetzt wird oder weist ein solches auf. Ein elektronisches Papier, das insbesondere hintergrundbeleuchtet sein kann, hat den Vorteil, das zur Anzeige einer gewünschten Graphik keine Erhaltungsspannung notwendig ist, wie es beispielsweise bei selbstleuchtenden Anzeigesystemen der Fall ist. Ein Spannungspuls wird lediglich zum Wechsel der Anzeige benötigt, so dass durch den Einsatz eines elektronischen Papiers eine dauerhafte und energiesparende Anzeige einer Graphik möglich ist. Bevorzugt kann das ein elektronisches Papier aufweisende Anzeigemittel sich zumindest im Wesentlichen über die gesamte Fläche der erfindungsgemäß verwendeten Folie erstrecken. Somit ist es möglich, eine nahezu beliebige Graphik, insbesondere ein bestimmtes Muster, anzuzeigen und so das optische Erscheinungsbild der Folie, und damit auch der mit der Folie beschichteten Oberfläche, zu definieren. Insbesondere lassen sich durch die Anzeige beispielsweise Maserungen von natürlichen Holz- und/oder Steinoberflächen imitieren. Vorzugsweise stellt in einem solchen Fall die wiedergegebene Graphik das nach außen hin sichtbare Dekorbild der Folie dar. Die Anzeigeeinrichtung, insbesondere das elektronische Papier, der Funktionsschicht erfüllt damit gleichzeitig die Funktion der Dekorschicht. Ein zusätzliche, separate Dekorschicht ist in diesem Fall nicht erforderlich, um einen bestimmten optischen Eindruck der Folie zu erzielen.

Elektronisches Papier ist derzeit prinzipbedingt auf die Darstellung von Grautönen zwischen schwarz und weiß beschränkt. Der Darstellung des Anzeigemittels lässt sich durch eine zusätzliche Farbfolie im Schichtaufbau der erfindungsgemäß verwendeten Folie, insbesondere oberhalb des Anzeigemittels, oder eine entsprechende farbige Tönung der Deckschicht ein zusätzlicher Farbeindruck verleihen. Hierdurch kann das optische Erscheinungsbild der Folie weiter an einen natürlichen Werkstoff angenähert werden. Es versteht sich, dass eine solche Farbfolie bzw. Tönung der Deckschicht auch in Verbindung mit einer statischen Dekorschicht eingesetzt werden kann.

Die Integration funktioneller Einheiten, insbesondere einer Leuchtschicht und/oder einer Anzeigeeinrichtung, in die erfindungsgemäß verwendete Folie erlaubt es, eine gewünschte Funktionalität bereitzustellen, gleichzeitig jedoch ein dezentes und ansprechendes optisches Erscheinungsbild einer mit der Folie beschichteten Oberfläche zu erreichen. Dies gilt insbesondere für den inaktiven Zustand der funktionalen Einheiten. Im Fall einer Leuchtschicht in der Funktionsschicht ist es beispielsweise möglich, die erfindungsgemäß verwendete Folie zu Beleuchtungszwecken einzusetzen, während im inaktiven Zustand kein Leuchtmittel sichtbar ist, beispielsweise wenn auf eine künstliche Beleuchtung verzichtet werden soll.

In Bezug auf die Ausgestaltung der Funktionsschicht versteht es sich, dass erfindungsgemäß auch eine beliebige Kombination von Sensoren, Aktoren oder anderen funktionellen Einheiten, wie beispielsweise einer Anzeigeeinrichtung, in der Funktionsschicht der verwendeten Folie vorgesehen sein kann.

Weist die Funktionsschicht wenigstens eine Leiterbahn auf, so kann elektrischer Strom in unauffälliger Weise, das heißt insbesondere ohne sichtbare Leitungen, und ohne aufwendige Arbeiten in oder hinter einem Belag an einem Boden, einer Wand oder einer Decke, zu einer Nutzungsstelle übertragen werden. Die Leiterbahn dient vorzugsweise zur Energieübertragung zu einem externen elektrischen Verbraucher. Extern bedeutet in diesem Zusammenhang, dass der Verbraucher nicht Teil der erfindungsgemäßen Verwendung der Folie ist, also mit dieser nur elektrisch gekoppelt oder koppelbar ist.

Zur Energieübertragung weist die Leiterbahn einen vergleichsweise größeren Leitungsquerschnitt auf als die leitenden Verbindungen einer beispielsweise als integrierter Schaltkreis ausgebildeten gedruckten Schaltung. Der Leitungsquerschnitt der Leiterbahn zur Energieübertragung beträgt vorzugsweise wenigstens 0,005 mm², bevorzugt wenigstens 0,01 mm², weiter bevorzugt wenigstens 0,05 mm² und besonders bevorzugt wenigstens 0,1 mm². Dadurch wird die Erwärmung der Leiterbahn bei der Stromleitung auf ein vertretbares Maß beschränkt, selbst wenn höhere Stromstärken zur Energieversorgung eines leistungsstärkeren Verbrauchers oder einer Mehrzahl von Verbrauchern übertragen werden.

Im Gegensatz zur Stromleitungen, die beispielsweise hinter einer Wand-, Boden- oder Deckenverkleidung vorgesehen sind, ist es durch die erfindungsgemäße Verwendung der Folie in einfacher Weise möglich, elektrische Energie an unterschiedlichen Orten nutzbar zu machen, ohne in vorhandene bauliche Gegebenheiten in größerem Maße eingreifen zu müssen. Um elektrische Energie letztlich zu einem elektrischen Verbraucher zu leiten, weist die Folie vorzugsweise wenigstens ein vorderseitig und/oder rückseitig und/oder stirnseitig bzw. randseitig der Folie angeordnetes Anschlusselement zur Kontaktierung der Leiterbahn, beispielsweise eine Steckerbuchse, eine Kontaktfläche o.ä., auf.

Bei einer bevorzugten Ausführungsform weist die Funktionsschicht eine Schnittstelle zur vorzugsweise kontaktlosen Übertragung von Energie und/oder von Daten auf. Hierzu weist die Schnittstelle vorzugsweise eine Induktionsspule auf. Die Schnittstelle kann zur Übertragung von elektrischer Energie und/oder Daten von einer Folie zu einer weiteren Folie dienen. Bei benachbart verlegten Folien erübrigt sich damit die Notwendigkeit einer leitenden Verbindung zwischen den beiden Folien, wenn eine Energie- oder Datenverbindung zwischen ihnen hergestellt werden soll. Die Schnittstelle ermöglicht darüber hinaus vorzugsweise auch einen Zugang zur Funktionsschicht bzw. zu funktionalen Elementen, das heißt beispielsweise zu Aktoren und Sensoren, von außen. Insbesondere lassen sich Daten kontaktlos zu einer optionalen Steuereinrichtung übertragen. Die Datenübertragung erfolgt dabei vorzugsweise über eine WLAN-Verbindung und/oder über das Bluetooth-Protokoll.

Darüber hinaus können elektronische Geräte, wie Smartphones, Tablet-Computer oder dergleichen, kontaktlos durch Induktion geladen werden. Hierzu weist die erfindungsgemäß verwendete Folie, die beispielsweise auf ein Möbelstück aufgebracht sein kann, vorzugsweise eine Induktionsspule bzw. eine entsprechende Induktionsfläche oder einen Induktionsbereich auf. Zu ladende Geräte werden für den Ladevorgang lediglich auf der Induktionsfläche abgelegt. Der kontaktlose Ladevorgang kann dabei insbesondere nach dem Qi- oder dem Powermat-Standard erfolgen.

Die erfindungsgemäß verwendete Folie zeichnet sich durch einen besonders einfachen und kostengünstig herzustellenden Aufbau aus, wenn die Funktionsschicht bzw. die gedruckte Schaltung der Funktionsschicht unmittelbar auf die Trägerschicht aufgedruckt ist. Alternativ oder zusätzlich kann die gedruckte Schaltung auch auf eine separate Schicht aufgebracht und diese mit der Trägerschicht verbunden werden. Durch einen direkten Druck auf die Trägerschicht wird jedoch ein besonders hoher Integrationsgrad erreicht. Die Gesamtdicke einer mit einer Funktionsschicht ausgestatteten Folie wird durch den Direktdruck der Schaltung auf die Trägerschicht nur in geringem Maß vergrößert. Zudem müssen in diesem Fall keine weiteren Schichten in den Schichtverbund der Folie eingefügt werden, wodurch die Herstellung der erfindungsgemäß Folie vereinfacht wird.

Ein weiterer Vorteil, der sich aus dem Aufbringen der gedruckten Schaltung auf eine separate Schicht ergibt, liegt dagegen darin, dass bei der Herstellung der erfindungsgemäß verwendeten Folie mit geringem Aufwand aus einer Vielzahl von vorbereiteten Funktionsschichten bedarfsweise wenigstens eine geeignete ausgewählt und dem Herstellungsprozess zugeführt werden kann. Dies kann insbesondere auch noch kurz vor dem Verpressen oder Laminieren der Folie erfolgen.

Durch wenigstens eine Bedienungseinrichtung zur Steuerung der Funktionsschicht kann ein Benutzer Einfluss auf das Verhalten eines Aktors in der Funktionsschicht nehmen. Die Bedienungseinrichtung, die vorzugsweise in der Funktionsschicht vorgesehen ist, kann darüber hinaus auch genutzt werden, um Steuersignale an ein funktionales Element zu leiten, das außerhalb des Schichtaufbaus der Folie angeordnet ist. Es kann somit beispielsweise eine Beleuchtungseinrichtung im Raum gesteuert werden, indem mit der Bedienungseinrichtung in der erfindungsgemäß verwendeten Folie interagiert wird.

Hierzu weist die Bedienungseinrichtung vorzugsweise wenigstens ein Bedienelement auf. Das Bedienelement kann zur Eingabe und/oder Ausgabe von Daten dienen und erfüllt somit die Funktion einer Benutzerschnittstelle. Neben der Eingabe von Steuerdaten kann auch eine Datenausgabe, beispielsweise in Form einer Rückmeldung an einen Benutzer, erfolgen.

Darüber hinaus ist eine Signalisierung für einen Benutzer möglich, wenn ein mittels eines Sensors gemessener Wert außerhalb eines vorgegebenen Bereichs liegt. Die Ausgabe von Daten durch das Bedienelement der Bedienungseinrichtung ist dabei nicht auf eine optische Ausgabe beschränkt, sondern kann alternativ oder zusätzlich auch eine mechanische und/oder akustische Signalisierung umfassen, beispielsweise in Form einer Vibration mit einer fühlbaren und/oder hörbaren Frequenz. Hierzu wird die Bedienungseinrichtung insbesondere mit einem mechanischen Aktor gekoppelt.

Zur Bedienung weist die Bedienungseinrichtung vorzugsweise wenigstens einen Druckschalter und/oder ein kapazitives Element auf. Ein Druckschalter dient dabei einfachen Schaltaufgaben und kann insbesondere als Taster dienen. Durch ein kapazitives Element ergeben sich darüber hinaus weitere Möglichkeiten der Bedienung. Beispielsweise lassen sich mit einem kapazitiven Element verschiedene Bereiche einer Eingabefläche zur Ausführung verschiedener Funktionen definieren. Ferner unterstützt ein kapazitives Element auch Bedienungsformen, die über die Funktion eines reinen Drucktasters hinausgehen. So erlauben beispielsweise Wisch- oder Touchgesten die Einstellung von Werten in Anlehnung an die Funktionsweise eines Schiebereglers anstelle der Eingabe eines konkreten Zahlenwertes. Damit kann beispielsweise eine Dimmersteuerung für eine Beleuchtungseinrichtung oder ähnliches realisiert werden.

Ein Druckschalter bzw. Drucksensor lässt sich besonders einfach durch ein piezoelektrisches Element realisieren. Da ein piezoelektrisches Element bei einer mechanischen Verformung des Piezokristalls von sich aus einen Potentialunterschied erzeugt, der als Spannung an zwei entsprechend angeordneten Elektroden messbar ist, ist die Verwendung eines piezoelektrischen Elements als Drucksensor grundsätzlich unabhängig von einer Energieversorgung.

Die Funktionsschicht und/oder der Sensor und/oder die Bedienungseinrichtung sind vorzugsweise mit einer Steuereinrichtung gekoppelt. Mittels der Steuereinrichtung lässt sich die Funktionsschicht bzw. lassen sich die funktionalen Elemente, beispielsweise Aktoren, steuern und/oder regeln, wobei die Steuerung bzw. Regelung auch lediglich bereichsweise erfolgen kann. Eine solche Steuereinrichtung ermöglicht es, über simple Schaltvorgänge hinausgehend auch komplexe Möglichkeiten der Ansteuerung von Aktoren in und außerhalb der Funktionsschicht zu realisieren. Insbesondere kann dies über Steuerprogramme der Steuereinrichtung erfolgen, die vorzugsweise über die Bedienungseinrichtung aufgerufen und aktiviert werden können.

Programmierte Steuerabläufe können darüber hinaus auch selbständig initiiert werden, wenn die Steuereinrichtung ein bestimmtes Sensorsignal registriert. Dies kann insbesondere mit dem Über- oder Unterschreiten eines vorgegebenen Sollwertes für eine physikalische Größe in Zusammenhang stehen.

Bei einer bevorzugten Ausgestaltung der Erfindung ist die Steuereinrichtung in die Funktionsschicht der verwendeten Folie integriert, wodurch eine äußerst kompakte Baugröße und ein hoher Integrationsgrad erreicht werden. Es ist in diesem Fall insbesondere nicht erforderlich, zusätzlich zur aufgebrachten Folie konstruktiv weitere Elemente zur Beherbergung der Steuereinrichtung vorzusehen.

Die Steuereinrichtung und/oder die Bedienungseinrichtung kann zudem auch fernsteuerbar ausgebildet sein. Hierbei ist sowohl eine Fernsteuerung durch vergleichsweise einfache Funk- und/oder Infrarotsignale als auch mittels komplexerer Methoden, beispielsweise mittels Bluetooth-Steuerung, möglich. Die Steuereinrichtung und/oder die Bedienungseinrichtung kann dementsprechend auch zum Datenaustausch ausgebildet sein. Eine Bluetooth-Schnittstelle erlaubt in diesem Zusammenhang sowohl die Übertragung digitaler Steuerdaten zur Steuerung funktionaler Elemente als auch eine Übermittlung beliebiger anderer Nutzdaten, wie beispielsweise Bilddaten, die über eine Anzeigeeinrichtung ausgegeben werden können.

Ein insbesondere mit einer Steuereinrichtung gekoppelter Datenspeicher erlaubt die Speicherung von übertragenen Daten zum Zweck eines zeitversetzten und/oder wiederholten Abrufs der Daten. Der Datenspeicher ist dabei vorzugsweise in der Funktionsschicht vorgesehen. Es versteht sich, dass auch eine Mehrzahl von Datenspeichern vorgesehen sein kann und dass diese beliebig miteinander in Verbindung stehen können.

Die Funktionsschicht kann darüber hinaus wenigstens einen Beschleunigungssensor zur Messung von insbesondere seismischen Erschütterungen aufweisen. Mittels des Beschleunigungssensors lassen sich Berührungen und/oder Bewegungen der Folie detektieren. Dies ermöglicht unter anderem die Überwachung eines Raumes auf das Betreten durch eine Person hin. Hierzu wird die erfindungsgemäß verwendete Folie vorzugsweise auf dem Boden angebracht, wo mittels des Beschleunigungssensors durch ein Betreten des Bodens hervorgerufene Erschütterungen registriert werden. Ferner erlaubt ein solcher Beschleunigungssensor in Bereichen, in denen die Dokumentation von seismischen Aktivitäten erforderlich ist, beispielsweise in Museen, die Messung unauffällig in Elemente des Raumes zu integrieren, indem eine Oberfläche, beispielsweise ein Abschnitt des Bodens oder einer Wand, mit der erfindungsgemäß verwendeten Folie beschichtet wird. Auf sichtbare und einer möglichen Manipulation ausgesetzte Messinstrumente kann somit verzichtet werden. Durch eine entsprechende Ausgestaltung der gedruckten Schaltung der Funktionsschicht lässt sich mit dieser ein Magnetfeld erzeugen. Hierbei kann insbesondere ein stationäres Magnetfeld erzeugt werden, das heißt ein Magnetfeld, das sich im zeitlichen Verlauf nicht oder nur unwesentlich ändert. Die gedruckte Schaltung ist dabei vorzugsweise derart ausgebildet, dass die Magnetfeldlinien zumindest teilweise außerhalb der Folie verlaufen. Somit können Objekte oder Geräte im Bereich der mit der Folie beschichteten Oberfläche mit dem Magnetfeld und damit mittelbar mit der Funktionsschicht der Folie interagieren. Eine Anwendung ist beispielsweise die Festlegung von Fahrwegen für selbstfahrende Objekte wie Spielzeuge, Staubsaugerroboter, o.ä.

Alternativ oder zusätzlich kann im Inneren der Folie, insbesondere in der Funktionsschicht und/oder in der Deckschicht, ein mit dem Magnetfeld wechselwirkendes Material vorgesehen sein. Hierbei kann es sich beispielsweise um ein ferromagnetisches Granulat oder ein Ferrofluid handeln. Ein solches Material ordnet sich bei Anwesenheit eines Magnetfeldes entsprechend den magnetischen Feldlinien an, wodurch das Material eine bestimmte räumliche Struktur erhält.

Ein Ferrofluid unter einer transparenten Deckschicht kann so beispielsweise zur Ausbildung bestimmter dekorativer Muster angeregt werden. Ein Granulat aus einem ferromagnetischen Material kann unterhalb oder innerhalb einer elastischen Deckschicht durch ein Magnetfeld derart angeordnet werden, dass sich an der Oberseite der Folie ein fühlbares Relief bildet. Ein solches Relief kann beispielsweise zur Rutschhemmung auf der Oberfläche oder zur Nachahmung einer natürlichen Oberflächenstruktur dienen.

Beim Abschalten des Magnetfeldes verlässt ein magnetempfindliches Material in der Regel die durch das Magnetfeld erzwungene Form wieder. Ein Muster bzw. eine Graphik, die durch ein Ferrofluid in Anwesenheit eines Magnetfelds gebildet wurde, verschwindet in diesem Fall. Ein durch eine entsprechende Anordnung eines magnetempfindlichen Granulats ausgebildete Reliefstruktur an der Oberfläche der Folie flacht wieder ab, so dass beispielsweise die Reinigung der Folie bzw. der Oberfläche mit der aufgebrachten Folie erleichtert wird.

Durch wenigstens ein photovoltaisches Element, insbesondere eine Photovoltaikzelle, lässt sich die Funktionsschicht energieautark betreiben. Die Notwendigkeit einer äußeren Energieversorgung über Zuleitungen für den Betrieb funktionaler Elemente entfällt dadurch. Insbesondere bei einem Einsatz der erfindungsgemäßen Folie im Außenbereich bzw. in Bereichen, die dem Tageslicht oder allgemein einer starken Beleuchtungsintensität ausgesetzt sind, ist auch eine Funktion der Folie als Energiequelle für weitere Verbraucher außerhalb der Funktionsschicht möglich.

Um Veränderungen bei der Bereitstellung von insbesondere elektrischer Energie, wie sie beispielsweise bei der Energieversorgung über ein photovoltaisches Element auftreten können, zu kompensieren, weist die Funktionsschicht vorzugsweise wenigstens einen Energiespeicher auf. Bei dem Energiespeicher kann es sich insbesondere um eine Dünnschichtbatterie oder eine sogenannte Mikrobatterie oder "Micro Energy Cell" (MEC) handeln. Eine solche Mikrobatterie kann insbesondere auch als gedruckte Schaltung in der Funktionsschicht vorgesehen sein.

Der Energiespeicher kann über ein photovoltaisches Element geladen werden. Darüber hinaus ist auch eine Ladung des Energiespeichers möglich, die auf dem piezoelektrischen Effekt beruht. Hierzu weist die Schaltung vorzugsweise ein piezoelektrisches Element auf, durch das infolge einer Druckausübung, beispielsweise beim Darüberlaufen, Ladungen getrennt und in dieser getrennten Form gespeichert werden. Alternativ oder zusätzlich kann auch eine Ladung des Energiespeichers über externe Zuleitungen, das heißt aus einer Energiequelle außerhalb der erfindungsgemäßen Folie, vorgesehen sein.

In einer weiteren bevorzugten Ausführungsform weist die Funktionsschicht der erfindungsgemäß verwendeten Folie eine insbesondere elektrisch betriebene Heizeinrichtung auf. Hierbei kommt vorzugsweise eine Widerstandsbeheizung zum Einsatz, bei der ein stromdurchflossener Leiter sich aufgrund seines Widerstands erwärmt und die Wärme an die Umgebung abgibt. Auf diese Weise lässt sich die erfindungsgemäß verwendete Folie als solche beheizen, so dass Wärme über die Ober- und Unterseite abgegeben werden, sofern nicht Maßnahmen zur Dämmung in eine Richtung vorgenommen werden.

Alternativ oder zusätzlich zu einer Widerstandsbeheizung kann auch ein Peltier-Element eingesetzt werden, um die Folie bereichsweise zu erwärmen. Die Temperaturveränderung basiert dabei auf dem Peltier-Effekt, nach dem ein Stromfluss eine Änderung des Wärmetransports bewirkt. Ein Peltier-Element besitzt daher stets eine warme und eine kühle Seite. Es lässt sich somit beispielsweise eine Folie konstruieren, die bei Anlegen eines Stromflusses an die Funktionsschicht an ihrer Unterseite abkühlt und an der Oberseite erwärmt wird, da Wärme von der einen auf die andere Seite transportiert wird. Die erfindungsgemäße Folie eignet sich somit zur Kühlung einer Oberfläche, während die Oberfläche bzw. die Folie auf der Oberfläche sich bei einer Berührung vergleichsweise warm anfühlt.

Es versteht sich, dass auch eine andere Anordnung der kühlen und der warmen Seite eines Peltier-Elements in der Funktionsschicht vorgesehen sein kann. Durch ein zusätzliches Kühlen der warmen Seite eines Peltier-Elements beispielsweise durch einen Luftzug, kann die kühle Seite weiter abgekühlt werden, so dass besonders tiefe Temperaturen erreicht werden. Entsprechendes gilt für eine Beheizung der kühlen Seite des Peltier-Elements, infolgedessen sich die warme Seite stärker erwärmt. Auf diese Weise eignet sich die erfindungsgemäß verwendete Folie zur Temperierung von Oberflächen, die mit der Folie beschichtet sind.

Bevorzugt ist die Trägerschicht und/oder die Dekorschicht und/oder die Deckschicht hinsichtlich ihrer Lichtdurchlässigkeit an die Funktionsschicht angepasst. Ist die Funktionsschicht in Form einer Leuchtschicht ausgebildet, kann die Dekorschicht und/oder die Deckschicht zumindest bereichsweise transparent oder transluzent bzw. semi-transparent ausgebildet sein. Entsprechendes gilt im Fall einer Anzeigeeinrichtung der Funktionsschicht. Durch die Transparenz der darüberliegenden Schichten wird die Funktionsschicht direkt erkennbar, so dass Licht einer Leuchtschicht oder von einer Anzeigeeinrichtung dargestellte Elemente erkennbar sind. Insbesondere im Fall einer Leuchtschicht ist es zudem möglich, dass eine Dekorschicht mit einem bestimmten Muster bzw. Dekorbild hintergrundbeleuchtet wird. Die Deckschicht ist in diesem Fall vorzugsweise transparent ausgestaltet. Mittels einer zumindest bereichsweise lichtundurchlässigen Deck- und/oder Dekorschicht können allerdings auch bewusst Bereiche der Funktionsschicht abgedeckt werden, so dass beispielsweise mechanische Aktoren oder die gedruckte Schaltung von außen nicht erkennbar sind.

Eine Abstrahlschicht im Schichtaufbau der Folie kann dazu dienen, von der Funktionsschicht abgegebene Licht- und/oder Wärmestrahlung zu reflektieren. Dies ist insbesondere in Kombination mit einer Leuchtschicht und/oder einer Heizeinrichtung in der Funktionsschicht von Bedeutung. Beispielsweise können durch die Anordnung einer solchen Abstrahlschicht unterhalb der Funktionsschicht Strahlungsverluste verringert und eine zur Oberseite der Folie, das heißt von der beschichteten Oberfläche weg, gerichtete Abstrahlung gewährleistet werden. Soll eine Beheizung der beschichteten Oberfläche erfolgen, versteht es sich, dass auch eine Anordnung der Abstrahlschicht oberhalb der Funktionsschicht mit einer Heizeinrichtung im Schichtverbund der erfindungsgemäß verwendeten Folie möglich ist.

Durch eine Anordnung oberhalb der Funktionsschicht kann eine Abstrahlschicht alternativ oder zusätzlich auch ungewünschte elektro-magnetische Emissionen, das heißt sogenannten Elektrosmog, insbesondere in Wohnbereiche hinein, vermeiden oder zumindest verringern. Die Abstrahlschicht kann zu diesem Zweck vollflächig in der Folie ausgebildet sein und/oder eine Gitterstruktur aufweisen, die eine gute Abschirmwirkung bei gleichzeitiger Gewichtsersparnis erreicht.

Darüber hinaus kann eine Kühlschicht vorgesehen sein, mittels derer sich beispielsweise Abwärme von elektronischen bzw. stromführenden Komponenten abführen lässt. Eine solche Kühlschicht kann ferner auch zur Temperierung der Folie dienen, beispielsweise um ein bestimmtes Temperaturempfinden bei der Berührung der Folie zu erzielen. Anders als beispielsweise bei einer Kühlung durch ein Peltier-Element ist eine derartige Kühlschicht vorzugsweise passiv ausgestaltet. Dies gelingt insbesondere durch ein sogenanntes Phasenwechselmaterial, welches auch bei Latentwärmespeichern eingesetzt wird. Ein solches Material kann eine große Wärmemenge aufnehmen, ohne dass sich seine Temperatur nennenswert erhöht, da seine latente Schmelzwärme, Lösungswärme und/oder Absorptionswärme deutlich größer ist als die Wärme, die es aufgrund seiner spezifischen Wärmekapazität aufnehmen kann. Durch eine Kühlschicht kann zudem die Temperatur in einem Raum mit der erfindungsgemäß verwendeten Folie beeinflusst werden.

Die Herstellung der erfindungsgemäß verwendeten Folie wird vereinfacht bzw. beschleunigt, wenn zur Herstellung der Funktionsschicht, das heißt insbesondere zum Aufbringen der gedruckten Schaltung, ein Standarddruckverfahren eingesetzt werden kann. Dazu weist die gedruckte Schaltung vorzugsweise ein mittels Digitaldruck und/oder Siebdruck und/oder Rollenoffsetdruck aufbringbares, leitfähiges Material auf. Weiter bevorzugt sind zudem leitfähige Materialien, die sich im Rotationstiefdruck, Tampondruck, Hochdruck, Flachdruck, Tiefdruck, Durchdruck und/oder sonstigen Druckverfahren aufbringen bzw. verarbeiten lassen. Hierbei lässt sich eine Tinte insbesondere gut bei einem Digitaldruckverfahren verarbeiten, während bei anderen Druckverfahren eine entsprechende Druckfarbe eingesetzt wird. Die Tinte bzw. Druckfarbe erhält ihre für die Schaltung erforderliche Leitfähigkeit dann vorzugsweise durch enthaltene leitfähige Partikel, wobei insbesondere Metallpigmente, vorzugsweise Silberpigmente, besonders geeignet sind. Alternativ oder zusätzlich lassen sich auch Nanotinten, Lösungsmitteltinten, Farbstofftinten, UV-aktivierbare Tinten und/oder sonstige Tinten, Druckfarben oder Lacke einsetzen.

Besondere Festigkeit und Stabilität erhält die erfindungsgemäß verwendete Folie durch eine insbesondere teil- oder durchimprägnierte Papierschicht, auf welche, vorzugsweise, eine Dekorschicht aufgebracht ist. Die Papierschicht kann insbesondere die Trägerschicht bilden oder einen Teil der Trägerschicht sein. Alternativ oder zusätzlich kann die Papierschicht auch unabhängig von der Trägerschicht der Folie als Träger des Dekors vorgesehen sein und somit die Dekorschicht als separate Lage im Schichtenverbund der Folie bilden.

Zu diesem Zweck eignet sich auch eine vorzugsweise transparente Folie. Die Trägerschicht und/oder die Dekorschicht kann in diesem Zusammenhang insbesondere als PP-, PE- und/oder PU-Folie ausgebildet sein oder eine solche aufweisen. Eine derart ausgebildete Trägerschicht weist gleichzeitig eine hohe mechanische Festigkeit gegen Reißen, Knicken und sonstige Beschädigungen auf, ist jedoch ausreichend flexibel, um ein leichtes Verarbeiten beim Verlegen der Folie zu gewährleisten.

Alternativ oder zusätzlich ist es bei der erfindungsgemäßen Verwendung der Folie auch möglich, dass die Dekorschicht unmittelbar auf die Funktionsschicht aufgedruckt ist. Die Funktionsschicht befindet sich in diesem Fall vorzugsweise zwischen der Dekorschicht und der Trägerschicht und ist auf diese Weise nicht nur von oben durch die Deckschicht, sondern auch von unten her durch die Trägerschicht gegen mechanische Beschädigungen geschützt, welche die Funktion einer gedruckten Schaltung beeinträchtigen können.

Die Funktionsschicht kann je nach Einsatz- bzw. Anwendungszweck sowohl vollflächig als auch teilflächig in der Folie vorgesehen sein. Die Ausbildung der Funktionsschicht kann also auf diejenigen Bereiche der Folie beschränkt sein, in denen funktionale Elemente vorgesehen sein sollen. Dies ist insbesondere von Bedeutung, wenn die Folie in bestimmten Bereichen zugeschnitten werden soll, beispielsweise um beim Verlegen einer bestimmten Kontur folgen zu können.

Als ein zusätzlicher Schutz der Funktionsschicht vor mechanischer Beschädigung, insbesondere durch Biegen oder durch eine Torsion der Folie, kann eine Stabilisierungsschicht als zusätzliche Schicht beitragen. Im Schichtverbund der erfindungsgemäß verwendeten Folie ist die Stabilisierungsschicht dazu vorzugsweise direkt angrenzend an die Funktionsschicht und/oder die Trägerschicht angeordnet. Insbesondere ein Glasfasermaterial oder ein Polymerstoff, wie beispielsweise Polyester, besitzt geeignete mechanische Eigenschaften, um als bevorzugtes Material für die Stabilisierungsschicht in Frage zu kommen.

Zusätzlich zu oder anstelle einer Stabilisierungsschicht kann auch eine Schutzschicht vorgesehen sein, welche die gedruckte Schaltung der Funktionsschicht vor mechanischer Beschädigung und Verschmutzung schützt. Eine solche Schutzschicht verhindert insbesondere das Auftreten von Unterbrechungen der Leiterbahnen und/oder von Kurzschlüssen. Zusätzlich kann eine solche Schutzschicht dazu dienen, die Funktionsschicht vor eindringender Feuchtigkeit zu schützen. Im Vergleich zu einer relativ starren Stabilisierungsschicht bleibt beim Einsatz einer solchen Schutzschicht zum Schutz der Funktionsschicht die Flexibilität der erfindungsgemäßen Folie im Wesentlichen erhalten. Vorzugsweise weist die Schutzschicht dazu einen insbesondere isolierenden Schutzlack auf oder besteht daraus.

Um die erfindungsgemäß verwendete Folie nicht nur auf einer Oberfläche in einfacher Weise aufbringen, sondern auch wieder ablösen zu können, ist die Haftschicht vorzugsweise zur Ausbildung einer lösbaren Verbindung mit einem Untergrund ausgebildet. Dies kann durch eine geeignete Wahl des Haftmittels erfolgen, wobei insbesondere die Gruppe der wiederablösbaren Klebstoffe als Material für die Haftschicht geeignet ist.

Es ist darauf hinzuweisen, dass der Begriff einer Haftschicht sich nicht ausschließlich auf die Verwendung von Klebstoffen zur Haftvermittlung beschränkt. Unter einer Haftschicht ist grundsätzlich jedes Mittel zu verstehen, das geeignet ist, die erfindungsgemäß verwendete Folie auf einer Oberfläche in Position zu halten. Neben den bereits erwähnten Klebstoffen zur Ausbildung einer reversiblen oder irreversiblen Verbindung der Folie mit einer Oberfläche stellen in diesem Zusammenhang auch beispielsweise das Prinzip einer statischen Aufladung, Magnetismus, eine Klettverbindung, Mikrosaugnäpfe oder die technische Nachahmung des aus der Natur bekannten Gecko-Effekts geeignete Haftmittel dar.

Es versteht sich, dass grundsätzlich verschiedene Haftmittel zur Ausbildung der Haftschicht kombiniert werden können. Werden verschiedene Haftmittel, das heißt insbesondere auf verschiedenen Wirkprinzipien basierende Haftmittel, in einem sich wiederholenden Muster in der Haftschicht angeordnet, lässt sich eine gute Anhaftung der Folie auf verschiedenen Oberflächen mit unterschiedlicher Oberflächenbeschaffenheit erzielen.

Je nach Art und Weise der Beschaffenheit der Haftschicht kann unterseitig der Folie eine Schutzfolie zur Abdeckung der Haftschicht vorgesehen sein. Eine solche Schutzfolie schützt die Haftschicht vor Verschmutzung und einem damit verbundenen Nachlassen der Haftwirkung. Zudem kann durch eine solche Schutzfolie auch das unbeabsichtigte Anhaften der erfindungsgemäß verwendeten Folie an einer beliebigen Oberfläche, insbesondere bei der Lagerung, unterbunden werden.

Im Hinblick auf ein einfaches Verarbeiten der Folie beim Verlegen bzw. Aufbringen der Folie auf eine Oberfläche ist die Folie bevorzugt als Bahn ausgebildet. Die Bahn kann dabei grundsätzliche eine beliebige Länge aufweisen, wobei die Breite der Bahn vorzugsweise zwischen 10 cm und 100 cm, bevorzugt zwischen 25 cm und 75 cm und besonders bevorzugt zwischen 40 cm und 60 cm beträgt. Es ist somit möglich, die erfindungsgemäß verwendete Folie in Rollenform bereitzustellen, so dass eine einfache Verarbeitung beim Verlegen möglich wird, wie sie beispielsweise von Tapeten oder von Auslegware bekannt ist.

Um auch größere Oberflächen mit der Folie beschichten zu können, ohne aber die Handhabung der Folie bei der Verwendung über Gebühr zu erschweren, ist die Folie vorzugsweise derart ausgestaltet, dass die Funktionalität der Funktionsschicht auch über mehrere Folienabschnitte gewährleistet sein kann. Hierzu ist insbesondere im Randbereich der Folie bevorzugt wenigstens ein Kontaktmittel zur vorzugsweise überlappenden Kontaktierung einer weiteren Folie vorgesehen. Dies kann im Randbereich durch entsprechende Kontaktflächen geschehen. Beim Verlegen können nun aneinander angrenzende Folien derart überlappend verlegt werden, dass sich eine leitende Verbindung zwischen den Funktionsschichten der Folien ausbildet. Es versteht sich, dass alternativ oder zusätzlich zu einer überlappenden Kontaktierung auch eine elektrisch leitende Verbindung zwischen zwei Folienabschnitten über aneinander angrenzende Kontaktmittel bzw. Kontaktflächen oder mittels anderer Verbindungsmittel, beispielsweise mittels einer Steckverbindung, realisiert werden kann.

Damit in einem Überlappungsbereich der Folien keine störenden Dickenunterschiede wahrnehmbar sind, weist die erfindungsgemäß verwendete Folie in einer bevorzugten Ausführungsform randseitig einen Abschnitt geringerer Dicke auf, dies kann insbesondere durch Verringerung der Dicke der Funktionsschicht und/oder der Trägerschicht erreicht werden.

Oftmals weisen Boden-, Wand- und/oder Deckenbeläge eine Mehrzahl von einzelnen Belagselementen auf. Soll eine solche Oberfläche mit der erfindungsgemäß verwendeten Folie beschichtet werden, so ist es möglich, dass die Folie mehrteilig ausgebildet ist, und die Teile der Folie auf verschiedene, insbesondere aneinander angrenzende, Belagselemente aufgebracht werden. Im Ergebnis ergibt sich so beispielsweise ein Gesamtdekorbild. Die Teile der Folie wirken vorzugsweise derart zusammen, dass die Funktionsschichten der einzelnen Folienteile miteinander in Verbinduna stehen und, falls gewünscht, als funktionale Einheit funktionieren. Insbesondere weisen in diesem Fall die Folienteile laterale Abmessungen auf, die den Abmessungen der Belagselemente des Belags jeweils zumindest im Wesentlichen entsprechen.

Ein weiterer Aspekt der Erfindung wird dargestellt durch einen Belag, insbesondere einen Boden-, Wand- oder Deckenbelag, mit wenigstens einem Belagselement. Das Belagselement kann dabei insbesondere als Plattenkörper ausgebildet sein, als Rollenmaterial vorliegen oder durch eine Kombination aus diesen gebildet sein. Das oder die Belagselemente können ihrerseits ein bestimmtes Dekor aufweisen, wenngleich dies nicht zwingend erforderlich ist. Wesentlich ist dagegen, dass die Belagselemente eine Oberflächenbeschaffenheit aufweisen, die das Aufbringen einer eine Haftschicht und eine Funktionsschicht aufweisenden Folie, insbesondere mit den zuvor beschriebenen Merkmalen, erlaubt. Die Folie, die zumindest bereichsweise, oberseitig auf dem Belagselement oder den Belagselementen angeordnet ist, bildet zusammen mit dem Belagselement bzw. den Belagselementen letztlich den Belag.

Aus der Erfindung ergibt sich somit die Möglichkeit der Verwendung eines zusammengesetzten Belags, bei dem die Belagselemente und eine auf die Belagselemente aufzubringende Folie separat hergestellt und erst beim Verlegen des Belags zusammengeführt werden. Die Belagselemente verleihen dem Belag dabei seine mechanischen Eigenschaften, das heißt insbesondere seine Härte, die Widerstandsfähigkeit gegen Verziehen oder Verformen, aber auch Dämmungs- und Dämpfungseigenschaften. Hiervon unabhängig wird dem erfindungsgemäßen Belag sein optisches Erscheinungbild in Form eines oberseitigen Dekors durch die Folie verlieren. Mit der erfindungsgemäß verwendeten Folie kann dem erfindungsgemäß verwendeten Belag zudem eine erweiterte Funktionalität mit aktiven Komponenten verliehen werden.

Die Entkopplung der mechanischen Aspekte des Belags von den optischen und funktionalen Aspekten bietet eine hohe Flexibilität in Bezug auf die Auswahl eines Belagselements mit den erforderlichen mechanischen Eigenschaften und die optische Erscheinung bzw. integrierte Funktionalität des Belags. Insbesondere müssen für einen konkreten Anwendungsfall nicht spezielle Plattenkörper oder ein Rollenmaterial als Belagselement in aufwendiger Weise im Ganzen gefertigt werden. Die Entscheidung, welches Dekor und/oder welche Funktionalität der Belag in Abhängigkeit von der Einbausituation und der gewünschten Nutzung erhalten soll, lässt sich also auch noch nachträglich treffen, das heißt insbesondere nach dem grundsätzlichen Einbau eines wesentlichen Teils des Belags in Form der Belagselemente.

Bevorzugt ist die Folie derart ausgebildet, dass sie mit dem Belagselement bzw. den Belagselementen lösbar verbunden ist. Dies ermöglicht ein einfaches Entfernen der Folie, beispielsweise um ihre Position zu korrigieren oder um die Folie zu einem späteren Zeitpunkt durch eine andere Folie zu ersetzen. Ist der Belag von den Belagselementen her an sich noch in gutem Zustand, die Oberfläche jedoch stark abgenutzt, lässt sich diese durch den simplen Austausch der Folie leicht ersetzen und der Belag damit als solcher instandsetzen. Um eine Wiederablösbarkeit der Folie auf den Belagselementen zu gewährleisten, ist, vorzugsweise, die Haftschicht der Folie derart ausgebildet, dass keine dauerhafte Verbindung mit einer Oberfläche, an der die Folie anhaftet, ausgebildet wird. Alternativ oder zusätzlich kann auch die Oberfläche des Belagselements entsprechend ausgestaltet sein, so dass eine dauerhafte Verbindung mit der Folie verhindert wird.

Eine besonders gute Anhaftung der Folie am Belagselement wird erreicht, wenn das Belagselement eine zur Haftschicht der Folie korrespondierende Haftschicht, insbesondere zur Ausbildung einer Mehrkomponentenverbindung zwischen der Folie und dem Belagselement, aufweist. Zur Ausbildung einer extrem festen und bedarfsweise dauerhaften Verbindung kann die Haftschicht der Folie beispielsweise eine Komponente eines Zweikomponentenklebstoffs aufweisen, während die andere Komponente auf der Oberfläche des Belagselements vorgesehen ist. Beim Aufbringen der Folie auf das Belagselement mischen sich die zwei Komponenten, wodurch eine Klebwirkung erzielt wird und eine feste Verbindung der Folie mit dem Belagselement erfolgt.

Eine Mehrkomponentenverbindung im Sinne der Erfindung liegt im übrigen auch dann vor, wenn andere Verbindungsmittel als ein Zweikomponentenklebstoff oder vergleichbare Klebstoffe zum Einsatz kommen. Hierzu zählen insbesondere auch lösbare Verbindungen wie eine Klettverbindung oder eine Verbindung aufgrund der Anziehungswirkung verschiedenartig gepolter Magnete.

Durch eine spezielle Ausgestaltung des Belagselements ist es zudem möglich, eine Funktionsschicht der Folie in unauffälliger Weise zu kontaktieren und somit mit Energie und/oder Daten zu versorgen. Hierzu kann wenigstens ein Kontaktelement vorgesehen sein. Das Kontaktelement kann als Steckverbindung zwischen der Folie und dem Belagselement ausgebildet sein. Bevorzugt ist jedoch eine Ausgestaltung des Kontaktelements in Form korrespondierender Kontaktflächen, wobei, vorzugsweise, wenigstens eine Kontaktfläche oberseitig am Belagselement vorgesehen ist und eine entsprechende Zahl korrespondierender Kontaktflächen an der Unterseite der Folie vorgesehen sind. Beim Aufbringen der Folie auf das Belagselement kommt es bei einer entsprechenden gegenseitigen Ausrichtung zu einem Kontakt zwischen den Kontaktflächen, wodurch eine elektrisch leitende Verbindung zustande kommt. Belagselementseitig können entsprechende Zuleitungen zu den Kontaktflächen sowohl im Belagselement selbst als auch separat von diesem und durch dieses hindurchgeführt vorgesehen sein. Im Ergebnis ist somit eine optisch unauffällige Energie- und/oder Datenversorgung der erfindungsgemäß verwendeten Folie bei einem erfindungsgemäß verwendeten Belag möglich.

Es versteht sich, dass auf der erfindungsgemäß verwendeten Folie auch ein weiterer Belag verlegt sein kann. In diesem Fall kann insbesondere auf eine Dekorschicht, die der Folie ein bestimmtes optisches Erscheinungsbild verleihen soll, verzichtet werden. Die Folie dient in diesem Fall vor allem dazu, eine erweiterte Funktionalität an einer Oberfläche auch dann auf einfache Weise und insbesondere nachträglich bereitgestellt werden, falls die Oberfläche letztlich mit einem Belag verkleidet werden soll, der sich nicht zum Aufbringen der Folie eignet. Dies ist beispielsweise bei textilen Verkleidungsmaterialien wie einem Teppich oder einer Tapete der Fall. Ist ein Teppich bereits verlegt, reicht es zur Nachrüstung der gewünschten Funktionen üblicherweise aus, den Teppich bereichsweise anzuheben und die erfindungsgemäß verwendete Folie in den betreffenden Bereichen auf die darunterliegende Oberfläche aufzubringen.

Weitere Merkmale, Vorteile und Anwendungsmöglichkeiten der vorliegenden Erfindung ergeben sich aus der nachfolgenden Beschreibung von Ausführungsbeispielen anhand der Zeichnung und der Zeichnung selbst. Dabei bilden alle beschriebenen und/oder bildlich dargestellten Merkmale für sich oder in beliebiger Kombination den Gegenstand der vorliegenden Erfindung, unabhängig von ihrer Zusammenfassung in den Ansprüchen oder deren Rückbeziehung.

Es zeigt
- Fig. 1: eine schematische Schnittdarstellung einer bevorzugten Ausführungs-form der erfindungsgemäß zu verwendenden Folie,
- Fig. 2: eine der Fig. 1 entsprechende Darstellung einer weiteren bevorzugten Ausführungsform der erfindungsgemäß zu verwendenden Folie,
- Fig. 3: eine der Fig. 1 entsprechende Darstellung der Folie aus Fig. 1 mit ei-ner zusätzlichen unterseitigen Schutzfolie,
- Fig. 4: eine schematische Darstellung einer Bahn der Folie aus Fig. 3 in seit-licher Ansicht,
- Fig. 5: eine der Fig. 4 entsprechende Darstellung einer Bahn der Folie aus Fig. 1 oder 2,
- Fig. 6: eine der Fig. 1 entsprechende Darstellung einer bevorzugten Ausfüh-rungsform des erfindungsgemäß zu verwendenden Belags mit der erfindungsgemäß zu verwendenden Folie,

- Fig. 7: eine schematische Darstellung einer Anwendungssituation einer be-vorzugten Ausführungsform der erfindungsgemäß zu verwendenden Folie bzw. des erfindungsgemäß zu verwendenden Belags,
- Fig. 8: eine der Fig. 7 entsprechende Darstellung einer weiteren bevorzugten Ausführungsform der erfindungsgemäß zu verwendenden Folie bzw. des erfindungsgemäß zu verwendenden Belags,
- Fig. 9: eine alternative Anwendungssituation einer bevorzugten Ausfüh-rungsform der erfindungsgemäß zu verwendenden Folie bzw. des erfindungsgemäß zu verwendenden Belags,
- Fig. 10: eine der Fig. 9 entsprechende Darstellung einer alternativen Anwen-dungssituation einer weiteren bevorzugten Ausführungsform der erfindungsgemäß zu verwendenden Folie,
- Fig. 11: eine der Fig. 9 entsprechende Darstellung einer alternativen Anwen-dungssituation einer weiteren bevorzugten Ausführungsform der erfindungsgemäß zu verwendenden Folie bzw. des erfindungsgemäß zu verwendenden Belags,
- Fig. 12: eine perspektivische schematische Darstellung einer alternativen An-wendungssituation einer bevorzugten Ausführungsform der erfindungsgemäß zu verwendenden Folie bzw. des erfindungsgemäß zu verwendenden Belags,
- Fig. 13: eine perspektivische schematische Darstellung einer weiteren An-wendungssituation der erfindungsgemäß zu verwendenden Folie,
- Fig. 14: eine schematische Darstellung eines weiteren Anwendungsbeispiels der erfindungsgemäß zu verwendenden Folie bzw. des erfindungsgemäß zu verwendenden Belags und
- Fig. 15: eine schematische Darstellung einer weiteren Anwendungssituation der erfindungsgemäß zu verwendenden Folie.

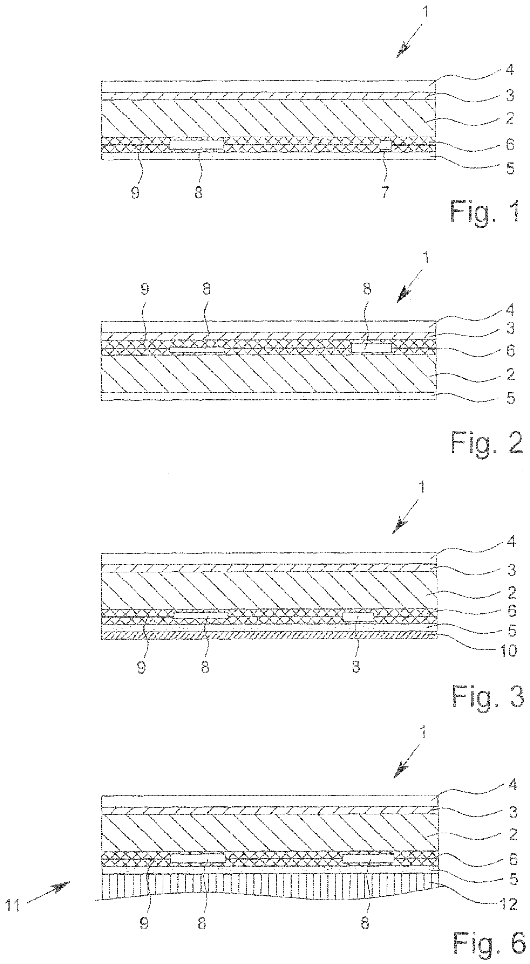

In der Schnittdarstellung gemäß Fig. 1 und 2 ist der Aufbau einer erfindungsgemäß verwendeten Folie 1 erkennbar. Die Folie 1 weist eine Mehrzahl von Schichten auf. Ihre Stabilität und ihren maßgeblichen Zusammenhalt erhält die erfindungsgemäß verwendete Folie 1 durch eine Trägerschicht 2. Die Trägerschicht 2 ist vorliegend als insbesondere imprägniertes Papier ausgebildet und gewährleistet damit eine gute mechanische Festigkeit und eine hohe Haltbarkeit der erfindungsgemäß verwendeten Folie 1.

Unmittelbar oberhalb der Trägerschicht 2 ist eine Dekorschicht 3 vorgesehen. Die Dekorfolie 3 ist in der Ausführungsform gemäß Fig. 1 direkt auf die Trägerschicht 2 aufgedruckt und verleiht der Folie 1 ihr von der Oberseite her sichtbares optisches Erscheinungsbild. Alternativ zu einem Direktdruck auf die Trägerschicht 2 kann die Dekorschicht 3 auch als eingelegte Folie ausgeführt sein, die bei der Herstellung der erfindungsgemäß verwendeten Folie 1 mit den weiteren Schichten des Schichtenaufbaus der Folie 1 verbunden wird.

Als oberste Schicht weist die Folie 1 in der in den Fig. 1 und 2 dargestellten Ausführungsform eine transparente Deckschicht 4 auf. Die Deckschicht 4 schließt den Schichtverbund der Folie 1 nach außen hin ab und schützt die darunterliegenden Schichten vor Beschädigung und mechanischer Abnutzung. Dies ist insbesondere von Bedeutung, wenn die erfindungsgemäß verwendete Folie 1 im Bodenbereich eingesetzt wird. Die Deckschicht 4 kann insbesondere eine bestimmte Oberflächenstruktur aufweisen, die der Folie 1 bestimmte anwendungsbezogene Eigenschaften, wie beispielsweise eine rutschhemmende Wirkung, verleiht oder durch die die Oberflächenstruktur eines natürlichen Werkstoffs imitiert wird.

Unterseitig der Folie 1 ist eine Haftschicht 5 vorgesehen, die zur Verbindung der Folie 1 mit einem Untergrund dient. Die Haftschicht 5 ist im vorliegenden Ausführungsbeispiel als wiederablösbare Klebschicht ausgebildet. Eine einmal verlegte Folie 1 kann somit vorzugsweise rückstandsfrei von einer Oberfläche wiederabgelöst werden. Hieraus ergibt sich der Vorteil, dass die Folie 1 bei einer Beschädigung oder bei einem Änderungswunsch, insbesondere des Dekors, leicht durch eine andere Folie 1 ersetzt werden kann.

Die erfindungsgemäß verwendete Folie 1 weist ferner eine Funktionsschicht 6 mit einer gedruckten Schaltung auf. Durch die Funktionsschicht 6 kann mit der Folie 1 eine Funktionalität bereitgestellt werden, deren Integration in vorhandene bauliche Gegebenheiten, wie beispielsweise vorhandene Boden-, Wand- oder Deckenbeläge oder in Möbelbauteile, nachträglich nicht oder nur mit erheblichem Aufwand möglich wäre.

Die Funktionalität wird dabei insbesondere bereitgestellt durch funktionale Elemente der Funktionsschicht 6. Hierzu gehören beispielsweise Sensoren 7, die einer Umwandlung einer physikalischen Größe in ein messbares elektrisches Signal dienen, und Aktoren 8, die im Gegenzug eine Umwandlung eines elektrischen Signals in eine Veränderung einer physikalischen Größe bewirken. Ferner können in der Funktionsschicht 6 Leiterbahnen 9 vorgesehen sein, die insbesondere der Energieübertragung in Form elektrischen Stroms zu einem nicht dargestellten elektrischen Verbraucher dienen. Ein solcher elektrischer Verbraucher kann in der Funktionsschicht 6 vorgesehen sein, oder aber außerhalb der Funktionsschicht 6 bzw. außerhalb der Folie 1 vorgesehen sein.

Zum Zweck der Kontaktierung eines solchen externen Verbrauchers weist die Folie 1 bzw. die Funktionsschicht 6 vorzugsweise ein nicht dargestelltes Anschlussmittel zur Kontaktierung eines elektrischen Verbrauchers auf. Hierbei kann es sich insbesondere um eine Steckerbuchse oder um Kontaktflächen handeln.

Die Funktionsschicht 6 befindet sich bei der in Fig. 1 dargestellten Ausführungsform unmittelbar unterhalb der Trägerschicht 2 und ist auf diese unmittelbar aufgedruckt. Die erfindungsgemäße Folie 1 lässt sich insbesondere dann besonders einfach herstellen, wenn die Funktionsschicht 6 bzw. die gedruckte Schaltung der Funktionsschicht 6 mittels Standarddruckverfahren auf ein Trägermaterial, insbesondere die Trägerschicht 2 der Folie 1, aufgedruckt werden kann. Zu diesem Zweck weist die gedruckte Schaltung vorliegend eine Silberpigmente aufweisende Tinte auf. Eine solche Tinte lässt sich insbesondere mittels einer Digitaldrucktechnik aufbringen und ist daher besonders leicht zu verarbeiten, um eine erfindungsgemäße Folie 1 herzustellen. Es versteht sich, dass im Fall einer anderen Drucktechnik wie beispielsweise dem Siebdruck und/oder dem Rollenoffsetdruck eine entsprechende, ebenfalls ein leitfähiges Material aufweisende Druckfarbe eingesetzt wird.

Die in Fig. 2 gezeigte Ausführungsform unterscheidet sich von der in Fig. 1 gezeigten Ausführungsform durch eine unterschiedliche Anordnung der Funktionsschicht im Schichtverbund der Folie 1. Im Fall der in Fig. 2 dargestellten Ausführungsform ist die Funktionsschicht 6 oberhalb der Trägerschicht 2 angeordnet, auf die sie ebenfalls unmittelbar aufgedruckt ist. Die Dekorschicht 3 ist ihrerseits unmittelbar auf die Funktionsschicht 6 aufgebracht.

Die Anordnung der Funktionsschicht 6 im Schichtverbund ist letztlich anwendungsabhängig. Lediglich die oberste und die unterste Schicht des Schichtverbunds werden bei der erfindungsgemäßen Folie 1 stets durch die Deckschicht 4 bzw. die Haftschicht 5 bzw. eine auf die Haftschicht 5 unterseitig aufgebrachte Schutzfolie 10 gebildet. Im Fall der in Fig. 1 gezeigten Anordnung der Funktionsschicht 6 unterhalb der Trägerschicht 2 ist die Funktionsschicht 6 besser gegenüber einer mechanischen Beschädigung von der Oberseite her geschützt. Die in Fig. 1 gezeigte Anordnung der Funktionsschicht 6 bietet sich an, wenn die Funktionsschicht 6 funktionale Einheiten aufweist, die zwar eine Funktionalität der Folie 1 bereitstellen, allerdings nicht von außen sichtbar sein sollen.

Weist die Funktionsschicht 6 dagegen eine Leuchtschicht oder eine Anzeigeeinrichtung auf, wird die Funktionsschicht 6 vorzugsweise oberhalb der vergleichsweise dicken Trägerschicht 2 angeordnet. Die Dekorschicht 3 ist in diesem Fall vorzugsweise lichtdurchlässig oder sogar zumindest bereichsweise transparent ausgebildet. Auf diese Weise kann das Dekor der Dekorschicht 3 hinterleuchtet werden oder das Dekor der Dekorschicht 3 wird um selbstleuchtende Elemente oder veränderbare Elemente einer Anzeigeeinrichtung ergänzt.

Es versteht sich, dass eine Anordnung der Funktionsschicht 6 oberhalb der Trägerschicht 2 mit einer zumindest bereichsweisen transparenten Dekorschicht 3 oberhalb der Funktionsschicht 6 auch in einem Fall vorgesehen sein kann, in dem die Funktionsschicht 6 weder eine Leuchtschicht noch eine Anzeigeeinrichtung oder sonstige Aktoren 8 aufweist, deren Funktion üblicherweise auf eine Wahrnehmbarkeit von außen gerichtet ist. Dies ist beispielsweise dann der Fall, wenn aus gestalterischen Gründen Leiterbahnen 9 oder allgemein die gedruckte Schaltung der Funktionsschicht 6 von außen wahrnehmbar sein soll, um der Folie 1 bewusst ein technisches Aussehen zu verleihen.

Die in Fig. 3 gezeigte Ausführungsform der erfindungsgemäß verwendeten Folie 1 entspricht im wesentlichen der in Fig. 1 gezeigten Ausgestaltung. Allerdings ist unterseitig eine zusätzliche Schutzfolie 10 vorgesehen, welche die Haftschicht 5 vor einer Verunreinigung schützt, wodurch die Haftwirkung der Haftschicht 5 vermindert werden könnte.

Die erfindungsgemäß verwendete Folie 1 lässt sich somit, wie in Fig. 4 dargestellt, als Bahn in einem aufgerollten Zustand lagern und transportieren, ohne dass die Haftschicht 5 ein Verkleben der Folie 1 mit sich selbst verursacht.

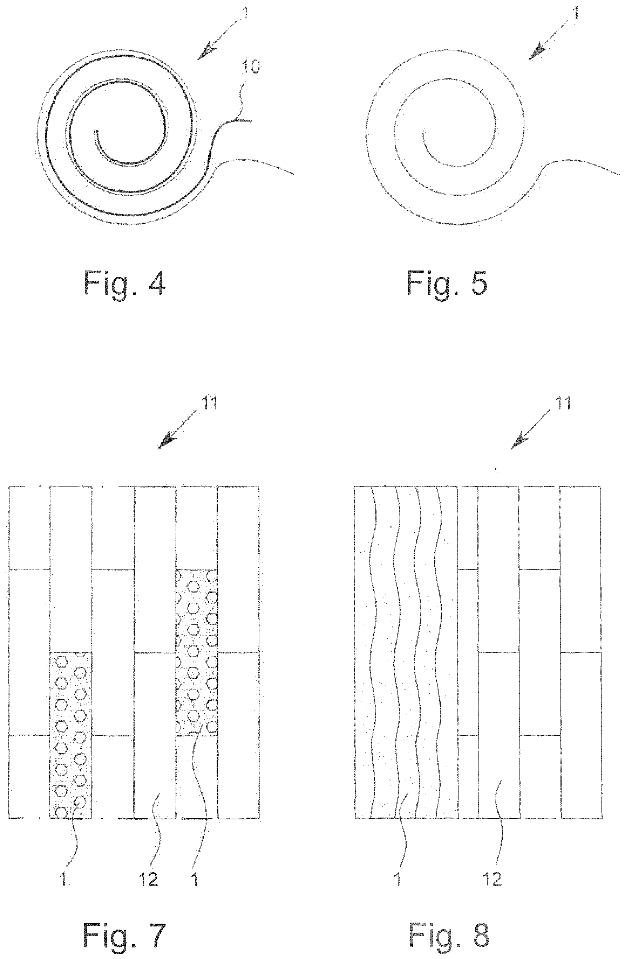

Bevorzugt ist jedoch insbesondere eine Ausführungsform der erfindungsgemäß verwendeten Folie 1, bei der die Haftschicht 5 ein Haftmittel, insbesondere einen Klebstoff, aufweist, das eine lösbare Verbindung mit einer Oberfläche eingehen kann. In diesem Fall kann auf eine Schutzfolie 10 verzichtet und die Folie 1 dennoch als Bahn in einem aufgerollten Zustand gelagert oder transportiert werden, wie dies in Fig. 5 dargestellt ist.

Die erfindungsgemäß verwendete Folie 1 lässt sich insbesondere mittels der Haftschicht 5 auf eine Oberfläche aufbringen, wie es beispielhaft in den Fig. 7 und 8 dargestellt und der Schnittdarstellung in Fig. 6 zu entnehmen ist. Dort ist ein Belag 11 dargestellt, der eine Mehrzahl von Belagselementen 12 aufweist. Auf die Belagselemente 12 ist nun die erfindungsgemäß verwendete Folie 1 in unterschiedlicher Weise aufgebracht. Bei der in Fig. 7 dargestellten Ausführungsform des erfindungsgemäß verwendeten Belags 11 ist die Folie 1 in einzelnen Abschnitten auf die Belagselemente 12 aufgebracht. Die Abschnitte weisen jeweils Abmessungen auf, die den oberseitigen Abmessungen der Belagselemente 12 entsprechen. Es ist somit möglich, einzelne Belagselemente 12 mit der erfindungsgemäß verwendeten Folie 1 zu beschichten und diese somit mit einem bestimmten Erscheinungsbild und insbesondere einer erweiterten Funktionalität zu versehen.

Alternativ kann die erfindungsgemäß verwendete Folie 1 auch als Bahn ausgeführt sein, wobei die in Fig. 8 gezeigte Ausführungsform einer Bahn eine Breite von etwa 50 cm aufweist. Die als Bahn vorliegende Folie 1 kann insbesondere als Rolle, wie in Fig. 4 und 5 dargestellt, bereitgestellt werden. Hieraus ergibt sich eine besonders einfache Möglichkeit, die erfindungsgemäß verwendete Folie 1 zu verarbeiten, da die Folie 1 zum Verlegen vorzugsweise auf der zu beschichtenden Oberfläche aus- bzw. abgerollt wird und ggfs. auf die gewünschte Länge zurechtgeschnitten wird. Bei dem in Fig. 8 gezeigten erfindungsgemäß verwendeten Belag 11 ist die Folie 1 derart aufgebracht, dass sie mehrere Belagselemente 12 überdeckt. Die Aufbringung der Folie 1 ist also grundsätzlich unabhängig von der Größe, Form und Beschaffenheit der Belagselemente 12 möglich.

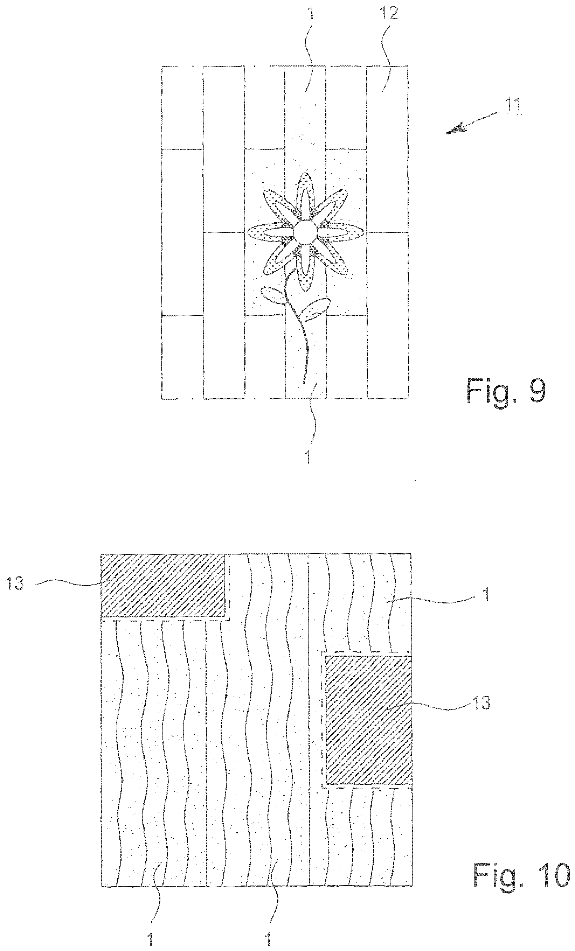

Bei der in Fig. 9 gezeigten bevorzugten Ausführungsform ist die Folie 1, ähnlich wie beim Beispiel der Fig. 7, mehrteilig ausgebildet, wobei die einzelnen Teile der Folie 1 jeweils von den Abmessungen her den Belagselementen 12 des Belags 11 entsprechen, die mit der Folie 1 beschichtet sind. Das Dekor der Dekorschicht 3 der Folie 1 ist bei den verschiedenen Teilen der Folie 1 unterschiedlich ausgebildet, und zwar derart, dass die unterschiedlichen Teildekore im Ergebnis durch ihre räumliche Anordnung auf der beschichteten Oberfläche kachelartig ein Gesamtdekorbild ergeben. Dabei ist es vorzugsweise, jedoch nicht zwingend, so, dass die Funktionsschichten 6 der einzelnen Teile der Folie 1 miteinander in Verbinduna stehen. Auf diese Weise lässt sich eine einheitliche Funktionalität auch über eine aus mehreren Teilen zusammengesetzte Folie 1 erreichten. Beispielsweise kann durch eine sich über mehrere Teile der Folie 1 erstreckende Leuchtschicht eine Hintergrundbeleuchtung des zusammengesetzten Dekors erzielen.

Bei einer weiteren bevorzugten Ausführungsform der erfindungsgemäß verwendeten Folie 1 kann diese so beschaffen sein, dass bei einer großflächigen oder vollflächigen Beschichtung einer Oberfläche, insbesondere in der in Fig. 10 gezeigten Weise mit Folienbahnen, bestimmte Freibereiche 13 ausgeschnitten werden können. Auf diese Weise lässt sich die erfindungsgemäß verwendete Folie 1 leicht an Konturen eines Raumes anpassen, die sich durch Vorsprünge, Versätze oder allgemein unregelmäßige Konturen der zu beschichtenden Oberfläche ergeben. Ferner lässt sich die Folie 1 auch um Möbel herum verlegen, so dass diese nicht im Vorhinein entfernt werden müssen. Dies vereinfacht die Verarbeitung der Folie 1 erheblich, insbesondere wenn die gewünschte Funktionalität und/oder das gewünschte Dekor nicht unter Möbeln, das heißt in einem in der Regel nicht nutzbaren bzw. nicht sichtbaren Bereich eines Bodens, benötigt wird.

Um die Folie 1 nachträglich zurechtschneiden zu können, kann die Funktionsschicht 6 derart ausgebildet sein, dass sie nur bereichsweise in der Folie 1 vorgesehen ist. In diesem Fall muss die spätere Position der Freibereiche 13 auf der Folie 1 bekannt sein und die Folie 1 beim Verlegen bereits entsprechend ausgerichtet werden. Alternativ oder zusätzlich kann die Funktionsschicht 6 auch derart ausgebildet sein, dass sie sich nicht bis zum Rand der Folie 1 erstreckt, so dass ein funktionsschichtfreier Bereich im Randbereich der Folie 1 besteht, in dem sie zur Angleichung an eine Randkontur frei zugeschnitten werden kann.

Je nach Art der integrierten Funktionalität kann die Funktionsschicht 6 allerdings auch derart beschaffen sein, dass sie zwar vollflächig in der Folie 1 vorgesehen ist, die Folie aber dennoch zuschneidbar bleibt. Dies ist beispielsweise bei einer Leuchtschicht unter Verwendung einer Elektrolumineszenzfolie der Fall. Eine solche Elektrolumineszenzfolie kann grundsätzlich frei zugeschnitten werden, ohne dass die Fähigkeit zur Lichtabgabe verlorengeht. Allein entscheidend ist letztlich, dass eine Verbindung zu den Kontaktpunkten der Elektroden zur Energieversorgung besteht.

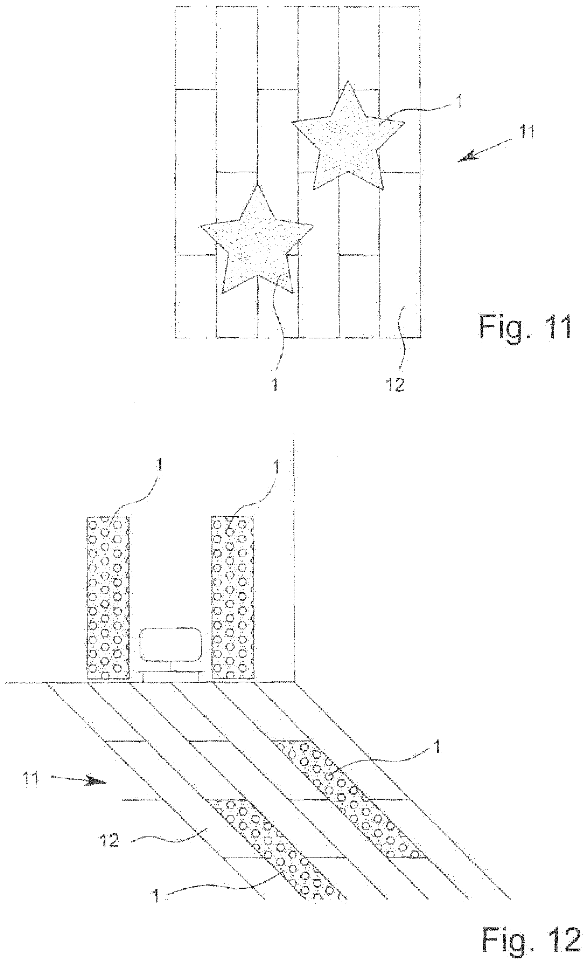

In ähnlicher Weise wie bei dem in Fig. 10 gezeigten Ausschneiden von Freibereichen 13 aus einer groß- oder vollflächig verlegten Folie 1 lassen sich auch Freiformelemente durch einen entsprechenden Beschnitt der Folie 1 herstellen, wie in Fig. 11 gezeigt ist. Hierbei kann zum einen ein Randbereich ohne Funktionsschicht 6 vorgesehen sein, der zur freien Bearbeitung und damit zur Formgestaltung dient. Zum anderen kann, wie bereits erläutert wurde, auch die Funktionsschicht 6 derart ausgebildet sein, dass sie zusammen mit der Folie 1 beschneidbar ist, ohne dass ihre Funktionalität verlorengeht. Darüber hinaus können Freiformelemente auch fertig produziert werden, wobei die geometrische Anordnung der funktionalen Elemente in der Funktionsschicht 6 bereits bei der Herstellung der Folie 1 an die spätere gewünschte Form angepasst wird. Auf diese Weise sind beliebig geformte Teile der Folie 1 herstellbar, die bei der Verarbeitung später frei auf einer Oberfläche, gegebenenfalls insbesondere unabhängig von der Größe und Anordnung einzelner Belagselemente 12, positionierbar sind.

Durch die Beschichtung unterschiedlicher Oberflächen mit der erfindungsgemäß verwendeten Folie 1 ist es insbesondere möglich, durch eine entsprechende Auswahl oder Ausgestaltung des Dekors der Dekorschicht 3 eine Dekorgleichheit zwischen den verschiedenen Oberflächen zu erzielen, wie es beispielshaft in Fig. 12 dargestellt ist. Hierbei ist es insbesondere nicht nur möglich, mehrere Oberflächen jeweils mit der erfindungsgemäß verwendeten Folie 1 zu beschichten, so dass sie letztlich ein identisches äußeres Erscheinungsbild erhalten. Die erfindungsgemäß verwendete Folie 1 erlaubt es darüber hinaus auch, bei einem vorhandenen Dekor einer ersten Oberfläche eine zweite Oberfläche derart mit der Folie 1 zu beschichten, dass das Dekor der zweiten Oberfläche dem Dekor der ersten Oberfläche entspricht. Dazu ist vorzugsweise die Dekorschicht 3 der Folie 1 mit einem Dekor versehen, das dem Dekor der ersten Oberfläche entspricht oder zumindest an dieses angelehnt ist. Insbesondere bei Holzmaserungen kommt es letztlich nicht auf eine identische Ausbildung des Dekors an. Die Dekore verschiedener Oberflächen werden in diesem Fall als zusammengehörig wahrgenommen, wenn die auftretenden Farbtöne und die typischen Abmessungen und Formen der Strukturen des Musters übereinstimmen. Es versteht sich, dass nicht nur Oberflächen verschiedener Beläge vom Dekor her aneinander angeglichen werden können, wie in Fig. 12 gezeigt ist. Mit der erfindungsgemäß verwendeten Folie 1 ist es ebenso möglich, das Dekor eines Möbelbauteils an ein Belagsdekor anzugleichen oder umgekehrt.

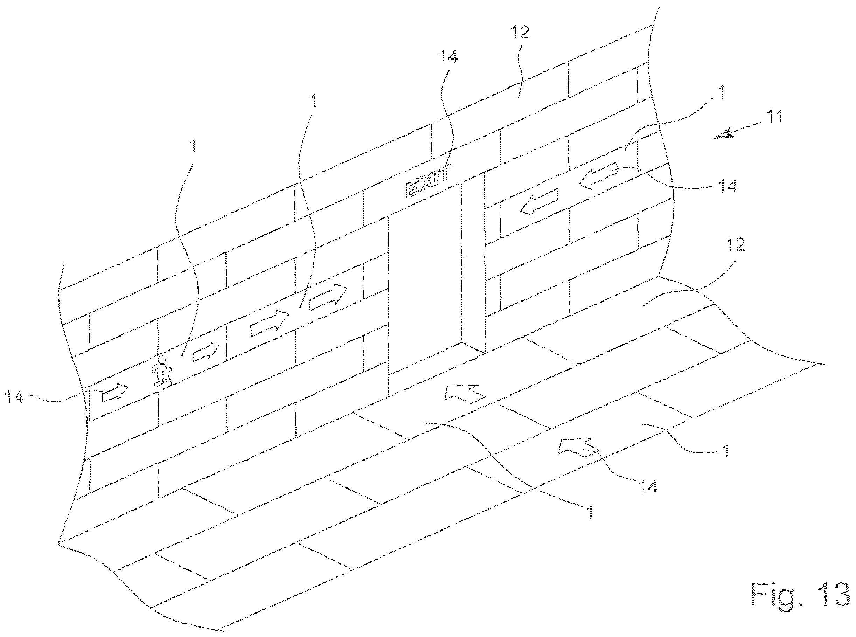

Bei der in Fig. 13 gezeigten Anwendung der erfindungsgemäß verwendeten Folie 1 sind einzelne Belagselemente 12 eines Boden- und eines Wandbelags mit der erfindungsgemäß verwendeten Folie 1 beschichtet. Die Funktionsschicht 6 der Folie 1 weist in diesem Fall eine Leuchtschicht auf, die das vorhandene Dekor der Dekorschicht 3 hinterleuchtet, wenn die Funktionsschicht 6 aktiviert wird.

In der in Fig. 13 gezeigten Ausführungsform eignet sich die erfindungsgemäß verwendete Folie bzw. der erfindungsgemäß verwendete Belag 11 insbesondere für den öffentlichen Bereich. Hierbei ist eine Vielzahl von Belagselementen 12 zu einem Boden- und Wandbelag angeordnet. Die erfindungsgemäß verwendete Folie 1 ist auf einer Mehrzahl von Belagselementen 12 vorgesehen und weist jeweils verschiedene Anzeigeelemente 14 auf, die im vorliegenden Anwendungsbeispiel zur Wegkennzeichnung durch eine Pfeildarstellung dienen oder alternativ als Beleuchtungselemente mit einer neutralen Formgebung eingesetzt werden können. Die Kennzeichnungswirkung der Anzeigeelemente 14 kann wie beim vorliegenden Beispiel insbesondere auf einen Notausgang oder einen allgemeinen Fluchtweg gerichtet sein.

Insbesondere in Verbindung mit einem solchen Wegeleitsystem kann die erfindungsgemäß verwendete Folie 1 in ihren weiteren Eigenschaften auf die Erhöhung der Sicherheit ausgerichtet sein. Beispielsweise kann wenigstens eine der Schichten der Folie 1 aus einem schwer entflammbaren Material ausgebildet sein oder der Schichtverbund der Folie 1 eine hier nicht dargestellte zusätzliche Schicht aus oder mit einem flammhemmenden Material aufweisen.

Ferner ist möglich, die Oberseite der Folie 1, insbesondere eine oberseitige Deckschicht 4 rutschhemmend auszubilden. Hierzu kann die Folie 1 bzw. die Deckschicht 4 ein oberseitiges Relief oder eine Aufrauhung aufweisen. Alternativ oder zusätzlich kann die Oberfläche der Folie 1 bzw. der Deckschicht 4 hierzu auch in gewissem Maße klebrig oder haftfähig ausgebildet sein, beispielsweise durch einen aufgetragenen Haftvermittler, der zur Ausbildung einer reversiblen Klebeverbindung geeignet ist, beispielsweise ein Pressure Sensitive Adhesive (PSA), oder durch eine elektrostatische Wirkung des Materials der obersten Schicht der Folie 1.

Durch eine vorzugsweise ebenfalls in der Funktionsschicht 6 der Folie 1 vorgesehene Steuereinrichtung lassen sich die Anzeigeelemente 14 bzw. die als Leuchtschicht ausgebildeten Aktoren 8 der Funktionsschicht 6 steuern. Die Steuereinrichtung kann insbesondere mit einem externen Hausalarmsystem gekoppelt sein. Im Alarmfall, das heißt wenn beispielsweise eine Evakuierung eines Bereichs erforderlich ist, können so zusätzliche Anzeigeelemente 14 aktiviert werden. Im Fall einer grundsätzlichen Nutzung der Leuchtschicht bzw. der Anzeigeelemente 14 zur allgemeinen Raumgestaltung durch Illumination wird durch die zusätzlichen Anzeigeelemente 14 erst im Alarmfall eine wegkennzeichnende Wirkung erreicht, wobei dann eine Kopplung mit einer Steuereinrichtung vorgesehen ist.

Durch eine entsprechende Ansteuerung der Leuchtschicht kann darüber hinaus ein Wechsel der Helligkeit und/oder des Leuchtmodus der Anzeigeelemente 14 bewirkt werden. Hierbei kann beispielsweise von einer statischen Beleuchtung zu einem Blinkmodus übergegangen werden, wodurch die Signalwirkung verstärkt wird. Zu diesem Zweck kann zusätzlich eine unterstützende akustische Signalisierung, insbesondere durch einen entsprechenden Aktor 8 in Form eines akustischen Signalgebers, vorgesehen sein.

Die erfindungsgemäß verwendete Folie 1 eignet sich insbesondere zur nachträglichen Ausstattung eines Raumbereichs mit funktionalen Elementen wie den in Fig. 13 dargestellten Anzeigeelementen 14. Dabei kann das Dekor der Dekorschicht 3 der Folie 1 derart gestaltet sein, dass sich die Folie 1 unauffällig in das Gesamtbild der Oberfläche des Belags 11 einfügt. Im inaktiven Zustand der Funktionsschicht 6, das heißt im unbeleuchteten Zustand, ist daher vorzugsweise keine Veränderung der Belagsoberfläche zu erkennen. Erst bei der Aktivierung der Funktionsschicht 6 der erfindungsgemäß verwendeten Folie 1 wird das Dekor im Bereich der Anzeigeelemente 14 hinterleuchtet, so dass die gewünschte Signalwirkung eintritt.

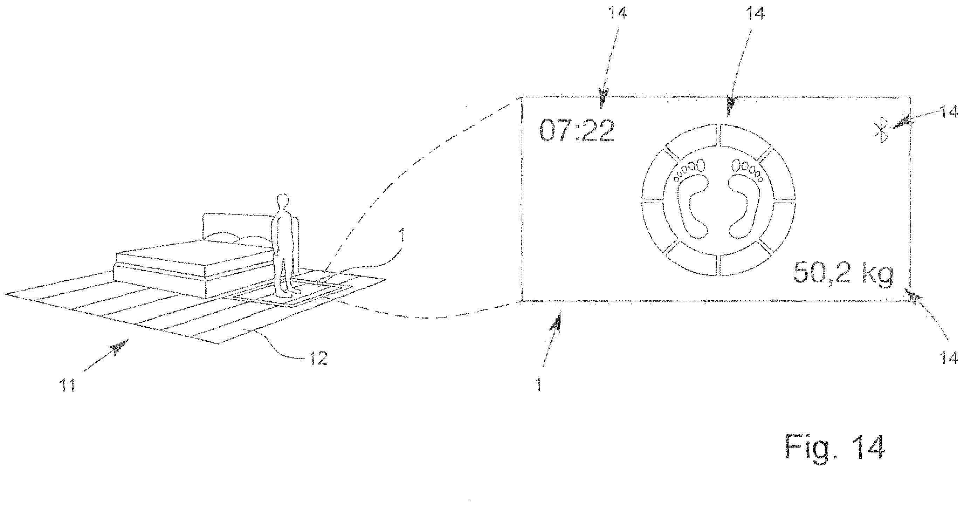

Eine weitere Anwendungssituation für die erfindungsgemäß verwendete Folie 1 ist beispielhaft in Fig. 14 wiedergegeben. Bei der hier dargestellten Ausführungsform wird in einem Wohnbereich, beispielsweise in einem Schlafzimmer, ein Bereich des Bodens mit der erfindungsgemäß verwendeten Folie 1 beschichtet. Somit erhält der Bodenbelag bereichsweise eine Funktionalität, die durch die funktionalen Elemente der Funktionsschicht 6 der Folie 1 bereitgestellt wird. Die funktionalen Elemente sind in der Funktionsschicht 6 in Form wenigstens einer gedruckten Schaltung vorgesehen. Es ist hierdurch möglich, die Funktionalität verschiedener, in der Regel jeweils gesondert vorhandener Gegenstände des Haushalts in dem mit der erfindungsgemäß verwendeten Folie 1 beschichteten Bereich zu vereinigen.

Beim vorliegenden Beispiel weist die Folie 1 zunächst die Funktionalität einer Zeitanzeige auf. Hierzu ist eine entsprechende Schaltung mit einem Zeitgeber in der Funktionsschicht 6 vorgesehen. Die Zeitanzeige kann auch als Funkuhr ausgebildet sein und die Funktionsschicht 6 zu diesem Zweck eine Empfangsschaltung für das Signal eines Zeitzeichensenders, wie beispielsweise DCF77, aufweisen.

Zur Visualisierung der Uhrzeit dient ein Anzeigeelement 14. Das Anzeigeelement 14 wird durch einen Aktor 8 in Form einer Leuchtschicht gebildet. Die Leuchtschicht hinter- bzw. durchleuchtet eine vorhandene Dekorschicht 3, so dass das Anzeigeelement 14 nur im aktiven Zustand sichtbar ist. Zur Darstellung verschiedener Zeichen ist die Leuchtschicht des Anzeigeelements 14 insbesondere bereichsweise aktivierbar. Alternativ kann das Anzeigeelemente 14 auch aus einer Vielzahl einzeln aktivierbarer Unterelemente, insbesondere Pixel, bestehen, die durch eine selektive Aktivierung gemeinsam ein Bild, vorzugsweise ein erkennbares Zeichen, ergeben.

Als Lichtquelle für die Leuchtschicht eignet sich wiederum eine Elektrolumineszenzfolie. Alternativ oder zusätzlich lässt sich eine Lichtabgabe in der gewünschten Form auch durch Einsatz einer oder mehrerer Leuchtdioden (LEDs), insbesondere organischer Leuchtdioden (OLEDs), bewirken. Ferner kann das Anzeigeelement 14 auch als elektronisches Papier ausgebildet sein, wie es typischerweise bei E-Book-Readern zum Einsatz kommt.

Zusätzlich zu der Zeitanzeige kann bei der dargestellten Ausführungsform auch eine Weckfunktion in die Funktionsschicht 6 der Folie 1 integriert sein. Hierzu weist die Funktionsschicht 6 vorzugsweise einen Aktor 8 in Form eines akustischen Signalgebers auf.

Ferner weist die in Fig. 14 dargestellte Folie 1 die Funktionalität einer Körperwaage auf. Die Erfassung des Körpergewichts eines Benutzers, der den mit der Folie 1 beschichteten Bereich betritt, wird dabei durch einen vorzugsweise als Drucksensor ausgebildeten Sensor 7 in der Funktionsschicht 6 oder einer separaten Sensorschicht realisiert. Die mittels des Sensors 7 gemessenen Gewichtsdaten werden über ein entsprechendes Anzeigeelement 14 visualisiert. Zusätzlich kann eine graphische Darstellung des Verlaufs des gemessenen Körpergewichts über einen gewissen Zeitraum dargestellt werden.

Hierzu werden die gemessenen Werte zusammen mit dem Zeitpunkt der Messung in einem Datenspeicher gespeichert und von einer Datenverarbeitungseinrichtung verarbeitet. Der Datenspeicher und/oder die Datenverarbeitungseinrichtung können in der Funktionsschicht 6 in Form einer gedruckten Schaltung vorgesehen sein. Darüber hinaus kann sich der Datenspeicher und/oder die Datenverarbeitungseinrichtung auch außerhalb der Folie 1 befinden.

Durch die Datenverarbeitungseinrichtung kann beispielsweise eine Bewertung der gemessenen Daten vorgenommen werden. Dies umfasst insbesondere den Vergleich eines gemessenen Werts mit einem Sollwert, wobei eine zu starke Abweichung vom Sollwert beispielsweise durch eine verschiedenfarbige Darstellung durch das Anzeigeelement 14 signalisiert werden kann.

Vorzugsweise weist die Folie 1 bzw. die Funktionsschicht 6 eine Schaltung mit den Eigenschaften einer Kommunikationseinrichtung auf. Hierdurch lassen sich insbesondere gemessene Daten vorzugsweise per Funk, bevorzugt über eine Bluetooth-Schnittstelle oder per WLAN, beispielsweise an eine außerhalb der Folie 1 angeordnete Datenverarbeitungseinrichtung übertragen. Möglich ist darüber hinaus auch eine Datenübertragung zu den funktionalen Elementen der Folie 1 hin. Somit lassen sich insbesondere Konfigurationsdaten übertragen, die etwa zum Einstellen einer Weckzeit und/oder zur Beeinflussung der Darstellung der Anzeigeelemente 14 dienen können.

Bei der in Fig. 14 dargestellten Folie 1 sind die Anzeigeelemente 14 derart ausgebildet, dass eine Anzeige durch eine Hinterleuchtung der Dekorschicht 3 erfolgt. Hierzu ist die Funktionsschicht 6 oberhalb der Trägerschicht 2 und vorzugsweise unmittelbar unterhalb der Dekorschicht 3 angeordnet. Es ist auf diese Weise möglich, die Anzeigeelemente 14 lediglich bei Benutzung erscheinen zu lassen, so dass sie bei Nichtbenutzung unsichtbar sind und das Dekor der Folie 1 unverändert erscheint. Ist das Dekor der Dekorschicht 3 der Folie 1 derart ausgestaltet, dass es dem Dekor der Belagselemente 12 des Belags 11 entspricht, ist die Funktionalität, die durch die erfindungsgemäß verwendete Folie 1 bereitgestellt wird, unauffällig in den Boden integriert, so dass sie nur bei der Benutzung in Erscheinung tritt.

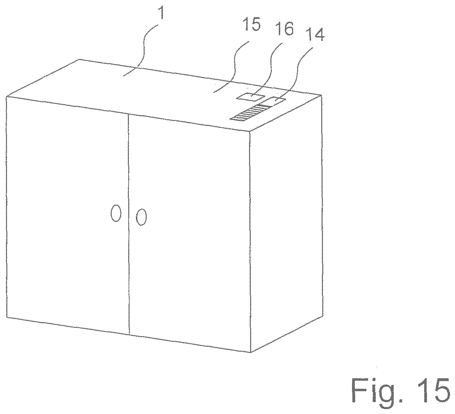

Eine weitere Anwendungsmöglichkeit ergibt sich durch die Beschichtung eines Möbelstücks oder eines Möbelbauteils mit der erfindungsgemäß verwendeten Folie 1. Dem Möbelstück wird auf diese Weise eine erweiterte Funktionalität und/oder ein verändertes äußeres Erscheinungsbild verliehen. Bei dem in Fig. 15 gezeitgen Möbelstück ist die oberseitige Deckplatte mit einer erfindungsgemäß verwendeten Folie 1 mit einer Funktionsschicht 6 beschichtet. Die Folie 1 weist im vorliegenden Anwendungsbeispiel einen Induktionsbereich 15 auf. Der Induktionsbereich 15 kann, wie hier dargestellt ist, auch nur bereichsweise auf der Folie 1 vorgesehen sein, sich jedoch auch vollflächig über diese erstrecken. Die Dekorschicht 3 der Folie 1 weist vorzugsweise ein Dekor auf, das dem Dekor der übrigen Bauteile des Möbelstücks, insbesondere der oberseitigen Deckplatte, entspricht. Somit wird dem Möbelstück eine Funktionalität in Form des Induktionsbereichs 15 hinzugefügt, wobei das optische Erscheinungsbild des Möbels nahezu unverändert bleibt, so dass es weiterhin als Bestandteil der übrigen Einrichtung eines Raums unverändert erhalten bleiben kann.

Geeignete elektronische Geräte, wie beispielsweise Smartphones, lassen sich im vorliegenden Beispiel durch simples Ablegen auf dem Möbelstück im Induktionsbereich 15 aufladen. Die Energieübertragung zum Aufladen erfolgt also kontaktlos durch die Funktion des Induktionsbereichs 15 als Ladevorrichtung.

Ferner kann die Ladetätigkeit bzw. der Ladestatus des geladenen Geräts durch ein insbesondere veränderliches Anzeigeelement 14 visualisiert werden.

Eine Bedienungseinrichtung mit einem Bedienelement 16, beispielsweise einem Taster, dient zur Bedienung des funktionalen Elements, das heißt im vorliegenden Fall der Ladevorrichtung, durch einen Benutzer. Mittels des Bedienelements 16 kann beispielsweise ein Ladestrom eingestellt oder ein Ladestatus abgefragt werden.

Die Energieversorgung der Folie 1 für den Betrieb des Induktionsbereichs 15 kann beispielsweise durch den Anschluss an das elektrische Versorgungsnetz realisiert werden. Dazu dient vorzugsweise ein nicht dargestelltes Anschlusselement zur Kontaktierung der Schaltung bzw. der Leiterbahn 9 in der Funktionsschicht 6 der Folie 1.

Die Lademöglichkeit für elektronische Geräte ist im Sinne einer Smart-Home-Anwendung unauffällig in das Möbelstück integriert. Ein spezielles Ladekabel oder eine Dockingstation ist dementsprechend nicht erforderlich. Insbesondere bei Nichtbenutzung der Ladefunktion ist der Induktionsbereich 15 als funktionales Element der Folie 1 bzw. des Möbelstücks nicht erkennbar, so dass das Möbelstück ein gewöhnliches Erscheinungsbild besitzt, von dem nicht ohne weiteres auf die integrierte Funktionalität geschlossen werden kann.

Es versteht sich, dass auch eine Beschichtung von Möbelbauteilen oder Belagselementen 12 mit der erfindungsgemäß verwendeten Folie 1 grundsätzlich vor dem Zusammenbau eines Möbelstücks oder vor dem Verlegen eines Belags 11 erfolgen kann.

### Bezugszeichenliste:

- 1: Folie
- 2: Trägerschicht
- 3: Dekorschicht
- 4: Deckschicht
- 5: Haftschicht
- 6: Funktionsschicht
- 7: Sensor
- 8: Aktor
- 9: Leiterbahn
- 10: Schutzfolie
- 11: Belag
- 12: Belagselement
- 13: Freibereich
- 14: Anzeigeelement
- 15: Induktionsbereich
- 16: Bedienelement

## Patentansprüche

1. Verwendung einer Folie (1) zur Beschichtung von Boden-, Wand- und/oder Deckenbelägen mit wenigstens einer Trägerschicht (2), wenigstens einer oberseitigen Deckschicht (4) und mit einer unterseitigen, als Klebschicht ausgebildeten Haftschicht (5), wobei zwischen der Haftschicht (5) und der Deckschicht (4) zumindest bereichsweise wenigstens eine Funktionsschicht (6) mit einer gedruckten Schaltung vorgesehen ist, wobei die Funktionsschicht (6) wenigstens eine Leiterbahn (9) zur Energieübertragung in Form elektrischen Stroms aufweist.

2. Verwendung einer Folie nach Anspruch 1, **dadurch gekennzeichnet, dass** die Funktionsschicht (6) wenigstens einen Sensor (7) zur Erfassung einer physikalischen Größe und/oder wenigstens einen Aktor (8), insbesondere in Form einer Leuchtschicht, eines mechanischen Aktors und/oder einer vorzugsweise als LC-Display und/oder als Matrixdisplay, insbesondere als elektronisches Papier, ausgebildeten Anzeigeeinrichtung aufweist.

3. Verwendung einer Folie nach Anspruch 1 oder 2, **dadurch gekennzeichnet, dass** die Funktionsschicht (6) wenigstens ein Anschlussmittel zur elektrischen Kontaktierung eines elektrischen Verbrauchers und/oder eine insbesondere eine Induktionsspule aufweisende, vorzugsweise als WLAN-, Bluetooth-, Qi- und/oder Powermat-Schnittstelle ausgebildete Schnittstelle zur bevorzugt kontaktlosen Übertragung von Energie und/oder Daten aufweist und/oder insbesondere im Randbereich der Folie (1) wenigstens ein Kontaktmittel zur vorzugsweise überlappenden und/oder angrenzenden Kontaktierung einer weiteren Folie (1), insbesondere ein Steckverbinder, vorgesehen ist.

4. Verwendung einer Folie nach einem der vorhergehenden Ansprüche, **dadurch gekennzeichnet, dass** der Funktionsschicht (6) eine vorzugsweise wenigstens ein Bedienelement (16) aufweisende Bedienungseinrichtung zur Steuerung der Funktionsschicht (6) zugeordnet ist, wobei die Bedienungseinrichtung vorzugsweise innerhalb der Folie (1), bevorzugt in der Funktionsschicht (6), vorgesehen ist und/oder dass die Funktionsschicht (6) mit einer Steuereinrichtung zur insbesondere bereichsweisen Steuerung und/oder Regelung der Funktionsschicht (6) gekoppelt ist.

5. Verwendung einer Folie nach einem der vorhergehenden Ansprüche, **dadurch gekennzeichnet, dass** die Funktionsschicht (6) wenigstens einen insbesondere mit einer Steuereinrichtung gekoppelten Datenspeicher und/oder wenigstens einen Energiespeicher, insbesondere eine Dünnschichtbatterie, und/oder wenigstens ein piezoelektrisches Element und/oder wenigstens ein photovoltaisches Element und/oder wenigstens einen Beschleunigungssensor, insbesondere zur Messung von Erschütterungen, aufweist, und/oder dass die gedruckte Schaltung zur Erzeugung eines insbesondere stationären Magnetfeldes ausgebildet ist und/oder dass die Folie (1) insbesondere im Bereich der Deckschicht (4) und/oder der Funktionsschicht (6) ein mit einem Magnetfeld wechselwirkendes Material aufweist.

6. Verwendung einer Folie nach einem der vorhergehenden Ansprüche, **dadurch gekennzeichnet, dass** die Funktionsschicht (6) eine insbesondere elektrisch betriebene, vorzugsweise widerstandsbeheizte und/oder ein Peltier-Element aufweisende, Heizeinrichtung aufweist und/oder dass eine Abstrahlschicht und/oder eine insbesondere ein Phasenwechselmaterial aufweisende Kühlschicht vorgesehen ist.

7. Verwendung einer Folie nach einem der vorhergehenden Ansprüche, **dadurch gekennzeichnet, dass** die Trägerschicht (2), die Dekorschicht (3) und/oder die Deckschicht (4) zumindest bereichsweise transparent, transluzent oder lichtundurchlässig ausgebildet ist und/oder dass die Dekorschicht (3) und/oder die Trägerschicht (2) eine vorzugsweise transluzente, insbesondere teil- oder durchimprägnierte Papierschicht und/oder eine vorzugsweise transparente Folie aufweist und/oder dass die Dekorschicht (3) unmittelbar auf die Funktionsschicht (6) aufgedruckt ist.

8. Verwendung einer Folie nach einem der vorhergehenden Ansprüche, **dadurch gekennzeichnet, dass** die gedruckte Schaltung ein mittels Digitaldruck, Siebdruck, Rollenoffsetdruck, Rotationstiefdruck, Tampondruck, Hochdruck, Flachdruck, Tiefdruck und/oder Durchdruck aufbringbares, leitfähiges Material, vorzugsweise eine insbesondere Metallpigmente, vorzugsweise Silberpigmente, aufweisende Tinte, Nanotinte, Lösungsmitteltinte, Farbstofftinte, UV-aktivierbare Tinte, Druckfarbe oder einen Lack, aufweist und/oder dass die Haftschicht (5) zur Ausbildung einer lösbaren Verbindung mit einem Untergrund ausgebildet ist und/oder dass unterseitig der Folie (1) eine Schutzfolie (10) zur Abdeckung der Haftschicht (5) vorgesehen ist.

9. Verwendung einer Folie nach einem der vorhergehenden Ansprüche, **dadurch gekennzeichnet, dass** zumindest bereichsweise eine Stabilisierungsschicht zum Schutz der Funktionsschicht (6) vor mechanischer Belastung vorgesehen ist.

10. Verwendung einer Folie (1) mit den Merkmalen nach einem der vorhergehenden Ansprüche zur Renovierung, Restaurierung und/oder Reparatur eines Boden-, Wand- und/oder Deckenbelags und/oder zur zumindest bereichsweisen Angleichung des Dekors zweier unterschiedlicher Beläge, insbesondere Boden-, Wand- und/oder Deckenbeläge.

11. Verfahren zur Beschichtung von eine Mehrzahl von Belagselementen (12) aufweisenden Boden-, Wand- und/oder Deckenbelägen mit einer Folie (1) mit den Merkmalen nach einem der Ansprüche 1 bis 9, wobei die Folie (1) mehrteilig ausgebildet ist und die Teile der Folie (1) auf verschiedene, insbesondere aneinander angrenzende, Belagselemente (12) und/oder Möbelbauteile aufgebracht werden, so dass sich ein Gesamtdekorbild ergibt und/oder die Teile der Folie (1) als funktionale Einheit zusammenwirken.

12. Verwendung eines Belages (11) als Boden-, Wand- oder Deckenbelag mit wenigstens einem Belagselement (12), insbesondere einem Plattenkörper und/oder einem Rollenmaterial,
**dadurch gekennzeichnet,**
**dass** oberseitig auf dem Belagselement (12) zumindest bereichsweise eine eine Haftschicht (5) und eine Funktionsschicht (6) aufweisende Folie (1) mit den Merkmalen nach einem der vorhergehenden Ansprüche 1 bis 9 vorgesehen ist.

13. Verwendung eines Belages nach Anspruch 12, **dadurch gekennzeichnet, dass** die Folie (1) mit dem Belagselement (12) lösbar verbunden ist und/oder dass das Belagselement (12) eine zur Haftschicht (5) der Folie (1) korrespondierende HaftSchicht, insbesondere zur Ausbildung einer Mehrkomponentenverbindung zwischen der Folie (1) und dem Belagselement (12) aufweist.

14. Verwendung eines Belages nach Anspruch 12 oder 13, **dadurch gekennzeichnet, dass** wenigstens ein Kontaktelement zur Ausbildung einer Kontaktierung zwischen einer Funktionsschicht (6) der auf das Belagselement (12) aufgebrachten Folie (1) und einer dem Belagselement (12) zugeordneten elektrischen Leitung vorgesehen ist.

## Claims

1. Use of a film (1) for coating floor, wall and/or ceiling coverings with at least one carrier layer (2), at least one top cover layer (4) and with a bottom bonding layer (5) in the form of an adhesive layer, wherein at least one functional layer (6) with a printed circuit is provided at least in some areas between the bonding layer (5) and the cover layer (4), wherein the functional layer (6) comprises at least one conductor track (9) for energy transmission in the form of electric current.

2. Use of a film according to claim 1, **characterized in that** the functional layer (6) comprises at least one sensor (7) for detecting a physical variable and/or at least one actuator (8), in particular in the form of a luminous layer, a mechanical actuator and/or a display device preferably designed as an LC display and/or as a matrix display, in particular as electronic paper.

3. Use of a film according to claim 1 or 2, **characterized in that** the functional layer (6) comprises at least one connecting means for electrically contacting an electrical consumer and/or an interface, in particular one comprising an induction coil, preferably designed as a WLAN, Bluetooth, Qi and/or Powermat interface for the preferably contactless transmission of energy and/or data and/or in particular in the edge region of the film (1) at least one contact means is provided for the preferably overlapping and/or adjacent contacting of a further film (1), in particular a plug connector.

4. Use of a film according to any one of the preceding claims, **characterized in that** an operating device is assigned to the functional layer (6), preferably having at least one operating element (16), for controlling the functional layer (6), the operating device preferably being provided within the film (1), preferably in the functional layer (6), and/or **in that** the functional layer (6) is coupled to a control device for controlling and/or regulating the functional layer (6), in particular in some regions.

5. Use of a film according to any one of the preceding claims, **characterized in that** the functional layer (6) comprises at least one data storage device, in particular coupled to a control device, and/or at least one energy storage device, in particular a thin-film battery, and/or at least one piezoelectric element and/or at least one photovoltaic element and/or at least one acceleration sensor, in particular for measuring vibrations, and/or **in that** the printed circuit is designed to generate a magnetic field, in particular a stationary magnetic field, and/or **in that** the film (1) has a material interacting with a magnetic field, in particular in the region of the cover layer (4) and/or the functional layer (6).

6. Use of a film according to any one of the preceding claims, **characterized in that** the functional layer (6) has a heating device, in particular electrically operated, preferably resistance-heated and/or having a Peltier element, and/or **in that** a radiating layer and/or a cooling layer, in particular having a phase change material, is provided.

7. Use of a film according to any one of the preceding claims, **characterized in that** the carrier layer (2), the decorative layer (3) and/or the cover layer (4) is designed to be transparent, translucent or opaque at least in some areas and/or that the decorative layer (3) and/or the carrier layer (2) has a preferably translucent, in particular partially or fully impregnated paper layer and/or a preferably transparent film and/or that the decorative layer (3) is printed directly onto the functional layer (6).

8. Use of a film according to any one of the preceding claims, **characterized in that** the printed circuit is a conductive material, preferably a conductive material which can be applied by means of digital printing, screen printing, web offset printing, rotogravure printing, pad printing, high printing, flat printing, gravure printing and/or through-printing, preferably a conductive material which is in particular a metal pigment, preferably silver pigment, having ink, nano-ink, solvent ink, dye ink, UV-activatable ink, printing ink or a lacquer, and/or **in that** the bonding layer (5) is designed to form a releasable connection with a substrate and/or **in that** a protective film (10) is provided on the underside of the film (1) to cover the bonding layer (5).

9. Use of a film according to any one of the preceding claims, **characterized in that** a stabilizing layer is provided at least in some areas to protect the functional layer (6) from mechanical stress.

10. Use of a film (1) having the features according to any one of the preceding claims for the renovation, restoration and/or repair of a floor, wall and/or ceiling covering and/or for the at least partial matching of the decoration of two different coverings, in particular floor, wall and/or ceiling coverings.

11. Process for coating floor, wall and/or ceiling coverings having a plurality of covering elements (12) with a film (1) having the features according to one of claims 1 to 9, wherein the film (1) is of multi-part design and the parts of the film (1) are applied to different, in particular adjoining covering elements (12) and/or furniture components, so that an overall decorative pattern is produced and/or the parts of the film (1) interact as a functional unit.

12. Use of a covering (11) as floor, wall or ceiling covering with at least one covering element (12), in particular a tile body and/or a roll material,
**characterized in that,**
**in that** a film (1) having a bonding layer (5) and a functional layer (6) and having the features according to one of the preceding claims 1 to 9 is provided on the top side of the covering element (12), at least in some areas.

13. Use of a covering according to claim 12, **characterized in that** the foil (1) is detachably connected to the covering element (12) and/or that the covering element (12) has an adhesive layer corresponding to the bonding layer (5) of the foil (1), in particular for forming a multi-component connection between the foil (1) and the covering element (12).

14. Use of a covering according to claim 12 or 13, **characterized in that** at least one contact element is provided for forming a contact between a functional layer (6) of the foil (1) applied to the covering element (12) and an electric line associated with the covering element (12).

## Revendications

1. Utilisation d'un film (1) pour le revêtement de revêtements de sol, de mur et/ou de plafond avec au moins une couche de support (2), au moins une couche de surface (4) sur la face supérieure et une couche adhérente (5) sur la face inférieure conçue comme une couche adhésive, au moins une couche fonctionnelle (6) avec un circuit imprimé étant disposée au moins par endroits entre la couche adhérente (5) et la couche de surface (4), la couche fonctionnelle (6) comportant au moins une piste conductrice (9) pour le transfert d'énergie sous forme de courant électrique.

2. Utilisation d'un film selon la revendication 1, **caractérisée en ce que** la couche fonctionnelle (6) comporte au moins un capteur (7) pour détecter une variable physique et/ou au moins un actionneur (8), en particulier sous la forme d'une couche luminescente, d'un actionneur mécanique et/ou d'un dispositif d'affichage formé de préférence comme un écran LCD et/ou en tant qu'écran matriciel, en particulier comme papier électronique.

3. Utilisation d'un film selon la revendication 1 ou 2, **caractérisée en ce que** la couche fonctionnelle (6) comporte au moins un moyen de connexion pour établir un contact électrique avec un consommateur électrique et/ou avec une interface, de préférence sous forme d'interface Wi-Fi, Bluetooth, Qi et/ou Powermat, comportant particulièrement une bobine d'induction, conçue pour la transmission de préférence sans contact d'énergie et/ou de données et/ou au moins un moyen de contact, en particulier dans la périphérie du film (1) pour une mise en contact de préférence chevauchante et/ou adjacente avec un autre film (1), en particulier un connecteur.

4. Utilisation d'un film selon l'une quelconque des revendications précédentes, **caractérisée en ce qu'**au moins un dispositif de commande comportant de préférence au moins un élément de commande (16) est associé à la couche fonctionnelle (6) pour commander la couche fonctionnelle (6), le dispositif de commande étant de préférence situé à l'intérieur du film (1), de préférence dans la couche fonctionnelle (6), et/ou **en ce que** la couche fonctionnelle (6) est couplée à un dispositif de commande pour la commande et/ou le réglage, en particulier par endroits, de la couche fonctionnelle (6).

5. Utilisation d'un film selon l'une quelconque des revendications précédentes, **caractérisée en ce que** la couche fonctionnelle (6) comporte au moins une mémoire de données, en particulier couplée à un dispositif de commande, et/ou au moins un accumulateur d'énergie, en particulier une batterie à couche mince, et/ou au moins un élément piézoélectrique et/ou au moins un élément photovoltaïque et/ou au moins un capteur d'accélération, en particulier pour mesurer les vibrations, et/ou **en ce que** le circuit imprimé est destiné à générer un champ magnétique, en particulier fixe, et/ou **en ce que** le film (1), en particulier dans la zone de la couche de surface (4) et/ou de la couche fonctionnelle (6), comporte un matériau qui interagit avec un champ magnétique.

6. Utilisation d'un film selon l'une quelconque des revendications précédentes, **caractérisée en ce que** la couche fonctionnelle (6) comporte un dispositif de chauffage, en particulier à commande électrique, de préférence chauffé par résistance et/ou comportant un élément Peltier, et/ou **en ce qu'**une couche de rayonnement et/ou une couche de refroidissement comportant en particulier un matériau à changement de phase sont présentes.

7. Utilisation d'un film selon l'une quelconque des revendications précédentes, **caractérisée en ce que** la couche support (2), la couche décorative (3) et/ou la couche de surface (4) est au moins par endroits transparente, translucide ou opaque et/ou **en ce que** la couche décorative (3) et/ou la couche support (2) comportent une couche de papier de préférence translucide, en particulier par endroits ou totalement imprégnée et/ou un film de préférence transparent et/ou **en ce que** la couche décorative (3) est imprimée directement sur la couche fonctionnelle (6).

8. Utilisation d'un film selon l'une quelconque des revendications précédentes, **caractérisée en ce que** le circuit imprimé est un matériau conducteur qui peut être appliqué au moyen de l'impression numérique, de l'impression offset rotative, de la rotogravure, de la tampographie, de la typographie, de la lithographie, de l'impression taille-douce et/ou de la sérigraphie, de préférence une encre, une nano-encre, une encre à solvant, une encre teintée, une encre activable aux UV, une encre d'impression comportant de préférence des pigments métalliques, de préférence des pigments argentés, ou un vernis, et/ou **en ce que** la couche adhésive (5) est conçue pour former une liaison détachable avec un substrat et/ou **en ce que** la face inférieure du film (1) comporte un film protecteur (10) pour recouvrir la couche adhésive (5).

9. Utilisation d'un film selon l'une quelconque des revendications précédentes, **caractérisée en ce qu'**une couche stabilisatrice est placée au moins par endroits pour protéger la couche fonctionnelle (6) des contraintes mécaniques.

10. Utilisation d'un film (1) ayant les caractéristiques selon l'une quelconque des revendications précédentes pour la rénovation, la restauration et/ou la réparation d'un revêtement de sol, de mur et/ou de plafond et/ou pour assortir au moins par endroits le décor de deux revêtements différents, en particulier de revêtements de sol, de mur et/ou de plafond.

11. Procédé pour le revêtement de revêtements de sol, de mur et/ou de plafond comportant une pluralité d'éléments d'enduction (12) avec un film (1) ayant les caractéristiques selon l'une des revendications 1 à 9, dans lequel le film (1) est formé en plusieurs parties et les parties du film (1) sont appliquées sur différents éléments d'enduction (12) et/ou éléments de mobilier, en particulier contigus, de sorte qu'il en résulte une image décorative globale et/ou que les parties du film (1) interagissent en tant qu'unité fonctionnelle.

12. Utilisation d'une enduction (11) comme revêtement de sol, de mur ou de plafond ayant au moins un élément d'enduction (12), en particulier un corps de panneau et/ou un matériau en rouleau,
**caractérisée en ce que**
la face supérieure de l'élément de revêtement (12) présente au moins par endroits un film (1) comportant une couche adhérente (5) et une couche fonctionnelle (6) ayant les caractéristiques selon l'une quelconque des revendications précédentes 1 à 9.

13. Utilisation d'un revêtement selon la revendication 12, **caractérisée en ce que** le film (1) est lié de manière détachable à l'élément d'enduction (12) et/ou **en ce que** l'élément d'enduction (12) comporte une couche adhésive correspondant à la couche adhérente (5) du film (1), en particulier pour la formation d'une liaison à plusieurs composants entre le film (1) et l'élément d'enduction (12).

14. Utilisation d'un revêtement selon la revendication 12 ou 13, **caractérisée en ce qu'**au moins un élément de contact sert à former un contact entre une couche fonctionnelle (6) du film (1) appliqué sur l'élément d'enduction (12) et une ligne électrique associée à l'élément d'enduction (12).
